# EUROPEAN PATENT APPLICATION

(11) **EP 3 070 998 A1**
(43) Date of publication of application: **21.09.2016**
(21) Application number: 14861563.6
(22) Date of filing: 12.11.2014
(51) Int. Cl.: H05B 33/02, C08G 73/06, C08L 79/04, H01L 51/50

(54) **ORGANIC ELECTROLUMINESCENT ELEMENT**

(30) Priority: 13.11.2013 JP 2013235441
(71) Applicant: Nissan Chemical Industries, Ltd., Chiyoda-ku Tokyo 101-0054 (JP)
(72) Inventor: SHIKAUCHI Yasufumi, Funabashi-shi Chiba 274-0052 (JP); NISHIMURA Naoya, Funabashi-shi Chiba 274-0052 (JP); NAKAIE Naoki, Funabashi-shi Chiba 274-0052 (JP)
(74) Representative: Bailey, Sam Rogerson
(86) International application number: PCT/JP2014/079928
(87) International publication number: WO 2015/072474

(57) **Abstract**

This organic electroluminescent element, which is provided with a light scattering film obtained by curing a composition for light scattering film formation containing, for example, a triazine ring-containing polymer represented by formula (AA), a crosslinking agent and a light-diffusing agent, has excellent current efficiency.

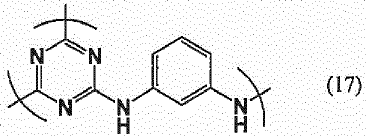

## Description

### TECHNICAL FIELD

This invention relates to an electroluminescence device having a light scattering film.

### BACKGROUND ART

Various efforts have hitherto been made to increase the functionality of polymer compounds. For example, in one approach currently used to increase the refractive index of polymer compounds, aromatic rings, halogen atoms or sulfur atoms are introduced onto the compounds. Of such compounds, episulfide polymer compounds and thiourethane polymer compounds, both of which have sulfur atoms introduced thereon, have been commercialized as high-refractive index lenses for eyeglasses.

The most effective way to achieve even higher refractive indices in polymer compounds is known to involve the use of inorganic metal oxides.

For example, a method for increasing the refractive index by using a hybrid material composed of a siloxane polymer mixed with a material containing small dispersed particles of zirconia, titania or the like has been disclosed (Patent Document 1).

A method in which a condensed ring skeleton having a high refractive index is introduced onto portions of a siloxane polymer has also been disclosed (Patent Document 2).

In addition, numerous attempts have been made to impart heat resistance to polymer compounds. Specifically, it is well known that the heat resistance of polymer compounds can be improved by introducing aromatic rings. For example, polyarylene copolymers with substituted arylene recurring units on the backbone have been disclosed (Patent Document 3). Such polymer compounds show promise primarily in use as heat-resistant plastics.

Melamine resins are familiar as triazine resins, but have very low decomposition temperatures compared with heat-resistant materials such as graphite.

The heat-resistant organic materials composed of carbon and nitrogen that have been used up until now are for the most part aromatic polyimides and aromatic polyamides. However, because these materials have linear structures, their heat-resistance temperatures are not all that high.

Triazine-based condensation materials have also been reported as nitrogen-containing polymer materials having heat resistance (Patent Document 4).

Lately, in the development of electronic devices such as liquid-crystal displays, organic electroluminescence (EL) displays, optical semiconductor (LED) devices, solid-state image sensors, organic thin-film solar cells, dye-sensitized solar cells and organic thin-film transistors, there has arisen a need for high-performance polymer materials.

The specific properties desired in such polymer materials include (1) heat resistance, (2) transparency, (3) high refractive index, (4) high solubility, and (5) low volume shrinkage.

The inventors earlier discovered that hyperbranched polymers containing recurring units with a triazine ring and an aromatic ring have a high refractive index, are capable of achieving high heat resistance, high transparency, high refractive index, high solubility and low volume shrinkage with the polymer alone, and are thus suitable as film-forming compositions in the manufacture of electronic devices (Patent Document 5). However, when employing cured films produced from such compositions as light extraction layers in organic EL devices or light emitting diodes, a better light extraction efficiency (current efficiency) is desired.

### PRIOR ART DOCUMENTS

### PATENT DOCUMENTS

Patent Document 1: JP-A 2007-246877
Patent Document 2: JP-A 2008-24832
Patent Document 3: USP 5,886,130
Patent Document 4: JP-A 2000-53659
Patent Document 5: WO 2010/128661

### SUMMARY OF THE INVENTION

### PROBLEMS TO BE SOLVED BY THE INVENTION

It is therefore an object of this invention to provide an organic electroluminescence device (sometimes referred to below as an "organic EL device") which includes a cured film containing a hyperbranched polymer having recurring units with triazine rings and aromatic rings, and is endowed with a good current efficiency.

### MEANS FOR SOLVING THE PROBLEMS

As a result of extensive investigations, the inventors have discovered that an organic EL device having a light scattering film obtained by curing a light scattering film-forming composition which includes a specific triazine ring-containing polymer, a crosslinking agent and a light diffusing agent is endowed with an excellent current efficiency.

Accordingly, the invention provides:
1. An organic electroluminescence device characterized by comprising a light scattering film obtained by curing a light scattering film-forming composition comprising a triazine ring-containing polymer which includes a recurring unit structure of formula (1) below 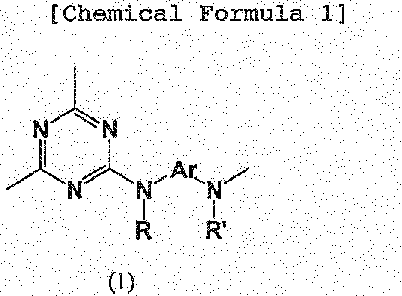 (wherein R and R' are each independently a hydrogen atom, an alkyl group, an alkoxy group, an aryl group or an aralkyl group; and Ar is at least one moiety selected from the group consisting of moieties of formulas (2) to (13) below 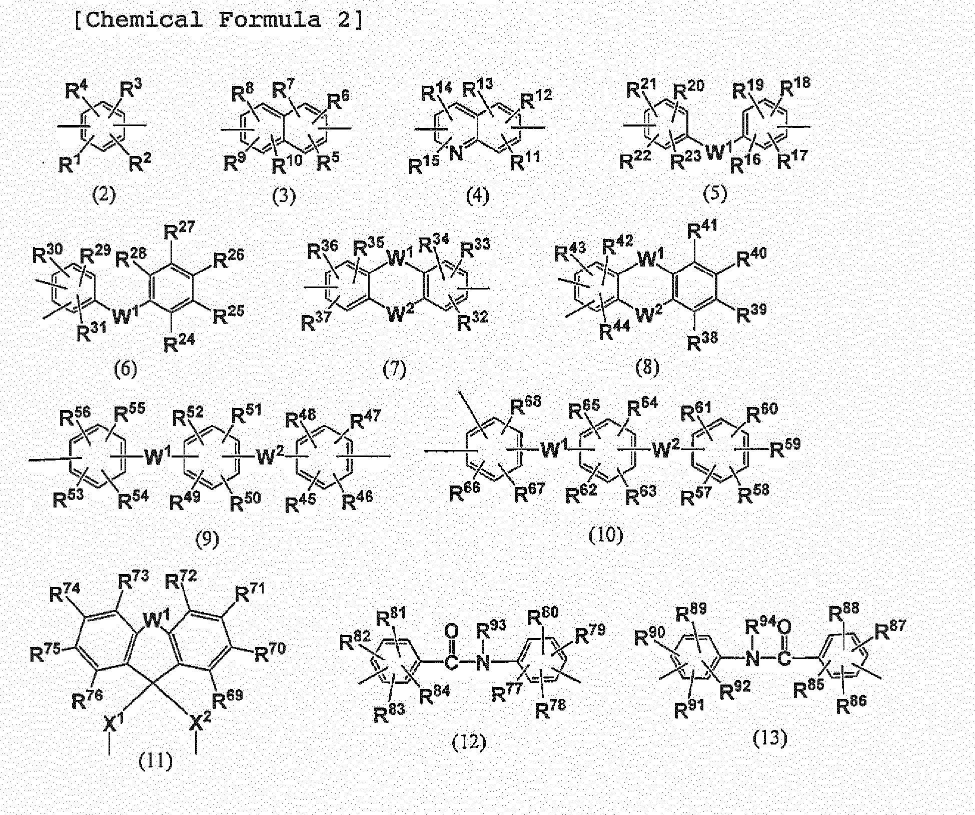 (in which R¹ to R⁹² are each independently a hydrogen atom, a halogen atom, a carboxyl group, a sulfo group, an alkyl group of 1 to 10 carbon atoms which may have a branched structure, or an alkoxy group of 1 to 10 carbon atoms which may have a branched structure; R⁹³ and R⁹⁴ are hydrogen atoms or alkyl groups of 1 to 10 carbon atoms which may have a branched structure; W¹ and W² are each independently a single bond, CR⁹⁵R⁹⁶ (R⁹⁵ and R⁹⁶ being each independently a hydrogen atom or an alkyl group of 1 to 10 carbon atoms which may have a branched structure, with the proviso that R⁹⁵ and R⁹⁶ may together form a ring), C=O, O, S, SO, SO₂ or NR⁹⁷ (R⁹⁷ being a hydrogen atom or an alkyl group of 1 to 10 carbon atoms which may have a branched structure); and X¹ and X² are each independently a single bond, an alkylene group of 1 to 10 carbon atoms which may have a branched structure, or a group of formula (14) below 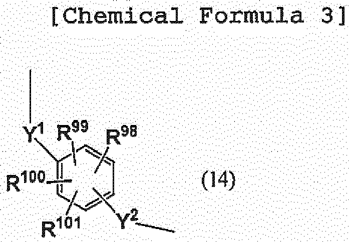 (R⁹⁸ to R¹⁰¹ being each independently a hydrogen atom, a halogen atom, a carboxyl group, a sulfo group, an alkyl group of 1 to 10 carbon atoms which may have a branched structure, or an alkoxy group of 1, to 10 carbon atoms which may have a branched structure; and Y¹ and Y² being each independently a single bond or an alkylene group of 1 to 10 carbon atoms which may have a branched structure))), a crosslinking agent, and a light diffusing agent;
2. The organic electroluminescence device of 1 above, wherein the light diffusing agent has an average particle size of 100 nm to 3 µm;
3. The organic electroluminescence device of 1 or 2 above, wherein the light diffusing agent is one or more selected from among organic-inorganic composite light diffusing agents, organic light diffusing agents and inorganic light diffusing agents;
4. The organic electroluminescence device of 3 above, wherein the light diffusing agent is titanium oxide;
5. The organic electroluminescence device of 4 above, wherein the light diffusing agent is titanium oxide treated with a surface modifying agent;
6. The organic electroluminescence device of 3 above, wherein the light diffusing agent is agglomerated silica particles;
7. The organic electroluminescence device of 6 above, wherein the light diffusing agent is agglomerated silica particles treated with a surface modifying agent;
8. The organic electroluminescence device of any one of 1 to 7 above, wherein the crosslinking agent is a blocked isocyanate-containing compound; and
9. The organic electroluminescence device of any one of 1 to 8 above, wherein the light scattering film forms a light extraction layer.

### ADVANTAGEOUS EFFECTS OF THE INVENTION

The light-scattering film-forming composition of the invention includes a specific triazine ring-containing polymer, a crosslinking agent, and a light diffusing agent, and is therefore able to efficiently produce a cured film having good light diffusing properties.

The resulting cured film can be advantageously used as a component in the fabrication of electronic devices such as liquid-crystal displays, organic EL devices (organic EL displays and organic EL lighting), optical semiconductor (LED) devices, solid-state image sensors, organic thin-film solar cells, dye-sensitized solar cells and organic thin-film transistors (TFTs). In particular, such cured films have excellent light-diffusing properties, and thus can be advantageously used as a light scattering layer (light extraction layer) material for organic EL devices and LEDs.

### BRIEF DESCRIPTION OF THE DIAGRAMS

[FIG. 1] FIG. 1 is an ¹H-NMR spectrum of Polymer Compound [3] obtained in Synthesis Example 1.
[FIG. 2] FIG. 2 is a plot showing the TG-DTA results for Polymer Compound [3] obtained in Synthesis Example 1.

### EMBODIMENT FOR CARRYING OUT THE INVENTION

The invention is described more fully below.

The organic EL device of the invention has a light scattering film obtained by curing a light scattering film-forming composition that includes a triazine ring-containing polymer which contains a recurring unit structure of formula (1) below, a crosslinking agent and a light diffusing agent.

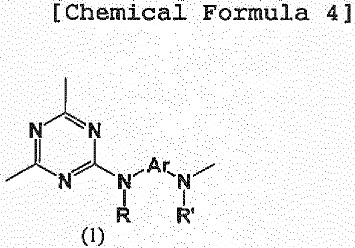

In the above formula, R and R' are each independently a hydrogen atom, an alkyl group, an alkoxy group, an aryl group or an aralkyl group.

In this invention, the number of carbon atoms on the alkyl group, although not particularly limited, is preferably from 1 to 20. To further increase the heat resistance of the polymer, the number of carbon atoms is more preferably from 1 to 10, and even more preferably from 1 to 3. The alkyl group may have a linear, branched or cyclic structure.

Illustrative examples of the alkyl group include methyl, ethyl, n-propyl, isopropyl, cyclopropyl, n-butyl, isobutyl, s-butyl, t-butyl, cyclobutyl, 1-methylcyclopropyl, 2-methylcyclopropyl, n-pentyl, 1-methyl-n-butyl, 2-methyl-n-butyl, 3-methyl-n-butyl, 1,1-dimethyl-n-propyl, 1,2-dimethyl-n-propyl, 2,2-dimethyl-n-propyl, 1-ethyl-n-propyl, cyclopentyl, 1-methylcyclobutyl, 2-methylcyclobutyl, 3-methylcyclobutyl, 1,2-dimethylcyclopropyl, 2,3-dimethylcyclopropyl, 1-ethylcyclopropyl, 2-ethylcyclopropyl, n-hexyl, 1-methyl-n-pentyl, 2-methyl-n-pentyl, 3-methyl-n-pentyl, 4-methyl-n-pentyl, 1,1-dimethyl-n-butyl, 1,2-dimethyl-n-butyl, 1,3-dimethyl-n-butyl, 2,2-dimethyl-n-butyl, 2,3-dimethyl-n-butyl, 3,3-dimethyl-n-butyl, 1-ethyl-n-butyl, 2-ethyl-n-butyl, 1,1,2-trimethyl-n-propyl, 1,2,2-trimethyl-n-propyl, 1-ethyl-1-methyl-n-propyl, 1-ethyl-2-methyl-n-propyl, cyclohexyl, 1-methylcyclopentyl, 2-methylcyclopentyl, 3-methylcyclopentyl, 1-ethylcyclobutyl, 2-ethylcyclobutyl, 3-ethylcyclobutyl, 1,2-dimethylcyclobutyl, 1,3-dimethylcyclobutyl, 2,2-dimethylcyclobutyl, 2,3-dimethylcyclobutyl, 2,4-dimethylcyclobutyl, 3,3-dimethylcyclobutyl, 1-n-propylcyclopropyl, 2-n-propylcyclopropyl, 1-isopropylcyclopropyl, 2-isopropylcyclopropyl, 1,2,2-trimethylcyclopropyl, 1,2,3-trimethylcyclopropyl, 2,2,3-trimethylcyclopropyl, 1-ethyl-2-methylcyclopropyl, 2-ethyl-1-methylcyclopropyl, 2-ethyl-2-methylcyclopropyl and 2-ethyl-3-methylcyclopropyl.

The number of carbon atoms on the alkoxy group, although not particularly limited, is preferably from 1 to 20. To further increase the heat resistance of the polymer, the number of carbon atoms is more preferably from 1 to 10, and even more preferably from 1 to 3. The alkyl moiety thereon may have a linear, branched or cyclic structure.

Illustrative examples of the alkoxy group include methoxy, ethoxy, n-propoxy, isopropoxy, n-butoxy, isobutoxy, s-butoxy, t-butoxy, n-pentoxy, 1-methyl-n-butoxy, 2-methyl-n-butoxy, 3-methyl-n-butoxy, 1,1-dimethyl-n-propoxy, 1,2-dimethyl-n-propoxy, 2,2-dimethyl-n-propoxy, 1-ethyl-n-propoxy, n-hexyloxy, 1-methyl-n-pentyloxy, 2-methyl-n-pentyloxy, 3-methyl-n-pentyloxy, 4-methyl-n-pentyloxy, 1,1-dimethyl-n-butoxy, 1,2-dimethyl-n-butoxy, 1,3-dimethyl-n-butoxy, 2,2-dimethyl-n-butoxy, 2,3-dimethyl-n-butoxy, 3,3-dimethyl-n-butoxy, 1-ethyl-n-butoxy, 2-ethyl-n-butoxy, 1,1,2-trimethyl-n-propoxy, 1,2,2-trimethyl-n-propoxy, 1-ethyl-1-methyl-n-propoxy and 1-ethyl-2-methyl-n-propoxy.

The number of carbon atoms on the aryl group, although not particularly limited, is preferably from 6 to 40. To further increase the heat resistance of the polymer, the number of carbon atoms is more preferably from 6 to 16, and even more preferably from 6 to 13.

Illustrative examples of the aryl group include phenyl, o-chlorophenyl, m-chlorophenyl, p-chlorophenyl, o-fluorophenyl, p-fluorophenyl, o-methoxyphenyl, p-methoxyphenyl, p-nitrophenyl, p-cyanophenyl, α-naphthyl, β-naphthyl, o-biphenylyl, m-biphenylyl, p-biphenylyl, 1-anthryl, 2-anthryl, 9-anthryl, 1-phenanthryl, 2-phenanthryl, 3-phenanthryl, 4-phenanthryl and 9-phenanthryl.

The number of carbon atoms on the aralkyl group, although not particularly limited, is preferably from 7 to 20. The alkyl moiety thereon may be linear, branched or cyclic.

Illustrative examples of the aralkyl group include benzyl, p-methylphenylmethyl, m-methylphenylmethyl, o-ethylphenylmethyl, m-ethylphenylmethyl, p-ethylphenylmethyl, 2-propylphenylmethyl, 4-isopropylphenylmethyl, 4-isobutylphenylmethyl and α-naphthylmethyl.

In the above formula, Ar is at least one moiety selected from among those of formulas (2) to (13) below.

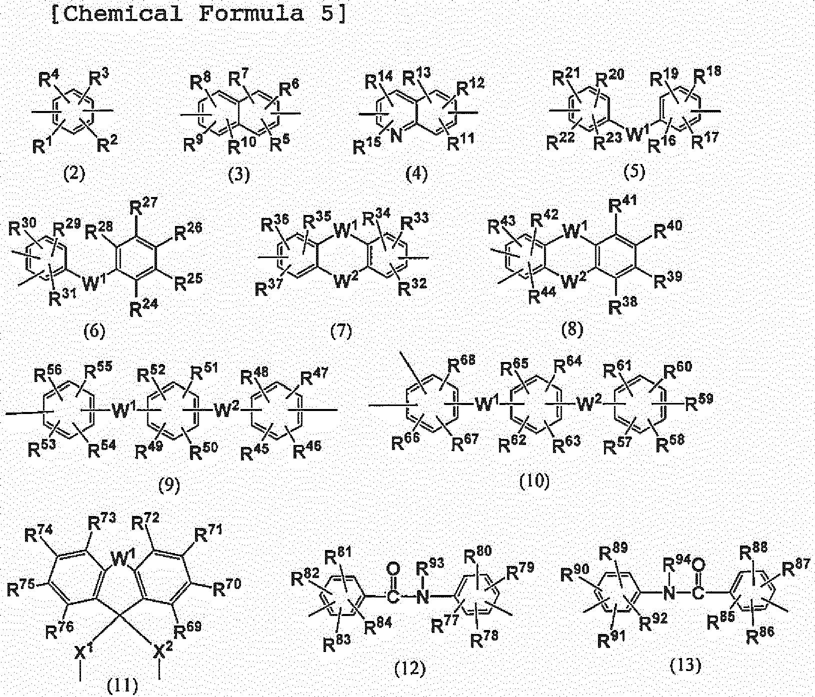

In the above formulas, R¹ to R⁹² are each independently a hydrogen atom, a halogen atom, a carboxyl group, a sulfo group, an alkyl group of 1 to 10 carbon atoms which may have a branched structure, or an alkoxy group of 1 to 10 carbon atoms which may have a branched structure. W¹ and W² are each independently a single bond, CR⁹⁵R⁹⁶ (wherein R⁹⁵ and R⁹⁶ are each independently a hydrogen atom or an alkyl group of 1 to 10 carbon atoms which may have a branched structure, with the proviso that R⁹⁵ and R⁹⁶ may together form a ring), C=O, O, S, SO, SO₂ or NR⁹⁷ (wherein R⁹⁷ is a hydrogen atom or an alkyl group of 1 to 10 carbon atoms which may have a branched structure). R⁹³ and R⁹⁴ are hydrogen atoms or alkyl groups of 1 to 10 carbon atoms which may have a branched structure.

Examples of the halogen atom include fluorine, chlorine, bromine and iodine.

These alkyl groups and alkoxy groups are exemplified by the same groups as mentioned above.

X¹ and X² are each independently a single bond, an alkylene group of 1 to 10 carbon atoms which may have a branched structure, or a group of formula (14) below.

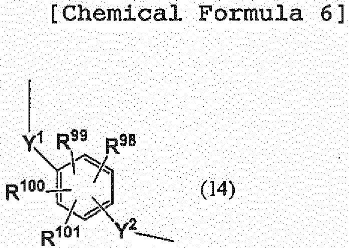

In the above formula, R⁹⁸ to R¹⁰¹ are each independently a hydrogen atom, a halogen atom, a carboxyl group, a sulfo group, an alkyl group of 1 to 10 carbon atoms which may have a branched structure, or an alkoxy group of 1 to 10 carbon atoms which may have a branched structure. Y¹ and Y² are each independently a single bond or an alkylene group of 1 to 10 carbon atoms which may have a branched structure. These halogen atoms, alkyl groups and alkoxy groups are exemplified by the same groups as mentioned above.

Illustrative examples of the alkylene group of 1 to 10 carbon atoms which may have a branched structure include methylene, ethylene, propylene, trimethylene, tetramethylene and pentamethylene.

In particular, Ar is preferably at least one moiety selected from among moieties of formulas (2) and (5) to (13), and more preferably at least one moiety selected from among moieties of formulas (2), (5), (7), (8) and (11) to (13). Illustrative examples of aryl groups of formulas (2) to (13) include, but are not limited to, those having the following formulas.

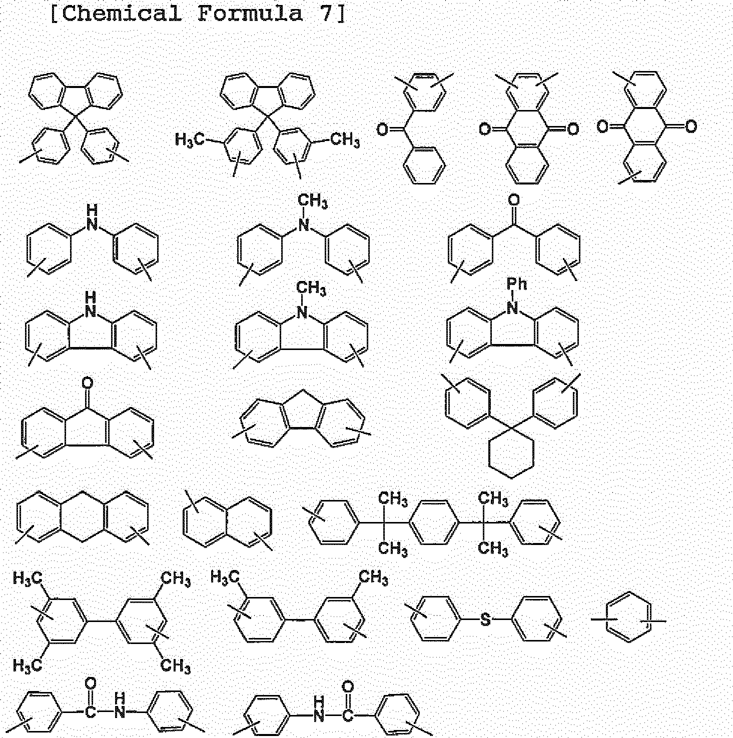

Of these, to obtain a polymer having a higher refractive index, aryl groups of the following formulas are more preferred.

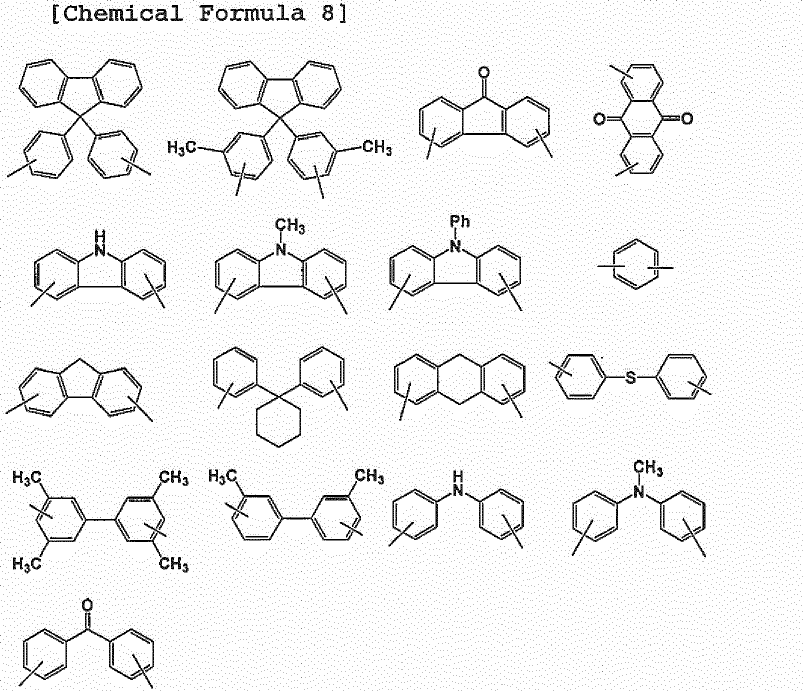

To further increase the solubility in very safe solvents such as resist solvents, it is preferable to include a recurring unit structure of formula (15) below.

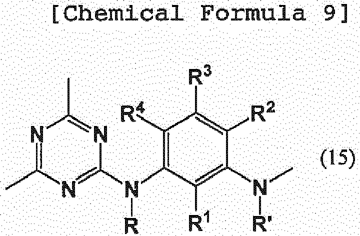

In this formula, R, R' and R¹ to R⁴ are as defined above.

From such a standpoint, especially preferred recurring unit structures include those of formula (16) below, with hyperbranched polymers of formula (17) below being most preferred.

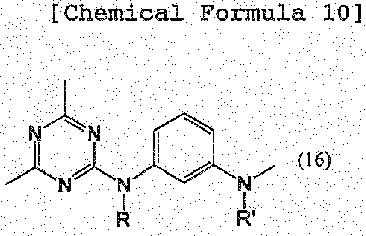

In this formula, R and R' are as defined above.

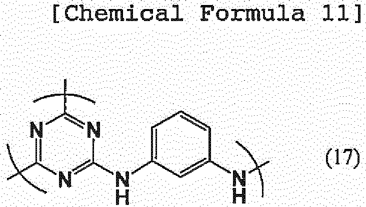

The polymer in this invention has a weight-average molecular weight which, although not particularly limited, is preferably between 500 and 500,000, and more preferably between 500 and 100,000. To further enhance the heat resistance and lower the shrinkage ratio, the weight-average molecular weight is preferably at least 2,000. To further increase the solubility and lower the viscosity of the resulting solution, the weight-average molecular weight is preferably not more than 50,000, more preferably not more than 30,000, and even more preferably not more than 10,000.

The weight-average molecular weight in the invention is the weight-average molecular weight measured by gel permeation chromatography (GPC) against a polystyrene standard.

The triazine ring-containing polymer in this invention may be prepared by the method disclosed in above-cited Patent Document 5.

For example, as shown in Scheme 1 below, a hyperbranched polymer having the recurring structure (17') can be obtained by reacting a cyanuric halide (18) with an m-phenylenediamine compound (19) in a suitable organic solvent. 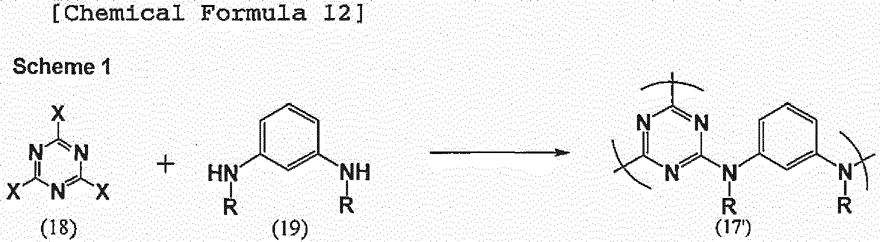 In the above formula, each X is independently a halogen atom. R is as defined above.

As shown in Scheme 2 below, a hyperbranched polymer having the recurring structure (17') can be synthesized from a compound (20) obtained by reacting equimolar amounts of a cyanuric halide (18) and an m-phenylenediamine compound (19) in a suitable organic solvent. 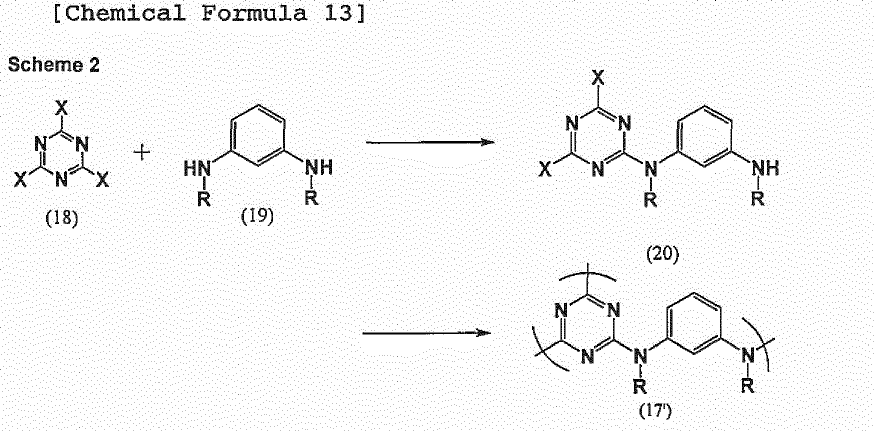 In the above formula, each X is independently a halogen atom. R is as defined above.

In the methods of Schemes 1 and 2, the respective starting materials may be charged in any suitable amounts so long as the target polymer is obtained, although the use of from 0.01 to 10 equivalents of the diamino compound (19) per equivalent of the cyanuric halide (18) is preferred.

In the method of Scheme 1 in particular, it is preferable to avoid using 3 equivalents of the diamino compound (19) per 2 equivalents of the cyanuric halide (18). By including the respective functional groups in amounts that are not chemically equivalent, the formation of a gel can be prevented.

To obtain hyperbranched polymers of various molecular weights which have many terminal triazine rings, it is preferable to use the diamino compound (19) in an amount of less than 3 equivalents per 2 equivalents of the cyanuric halide (18).

On the other hand, to obtain hyperbranched polymers of various molecular weights which have many terminal amines, it is preferable to use the cyanuric halide (18) in an amount of less than 2 equivalents per 3 equivalents of the diamino compound (19).

For example, in cases where a thin film has been produced, in order for the film to have an excellent transparency and light resistance, a hyperbranched polymer having many terminal triazine rings is preferred.

By suitably regulating the amounts of the diamino compound (19) and the cyanuric halide (18) in this way, the molecular weight of the resulting hyperbranched polymer can be easily regulated.

Various solvents that are commonly used in this type of reaction may be used as the organic solvent. Illustrative examples include tetrahydrofuran, dioxane, dimethylsulfoxide; amide solvents such as N,N-dimethylformamide, N-methyl-2-pryrrolidone, tetramethylurea, hexamethylphosphoramide, N,N-dimethylacetamide, N-methyl-2-piperidone, N,N-dimethylethyleneurea, N,N,N',N'-tetramethylmalonamide, N-methylcaprolactam, N-acetylpyrrolidine, N,N-diethylacetamide, N-ethyl-2-pyrrolidone, N,N-dimethylpropionamide, N,N-dimethylisobutyramide, N-methylformamide and N,N'-dimethylpropyleneurea; and mixed solvents thereof.

Of the above, N,N-dimethylformamide, dimethylsulfoxide, N-methyl-2-pyrrolidone, N,N-dimethylacetamide, and mixed solvents thereof are preferred. N,N-Dimethylacetamide and N-methyl-2-pyrrolidone are especially preferred.

In the Scheme 1 reaction and the second stage reaction in Scheme 2, the reaction temperature may be suitably set in the range from the melting point of the solvent used to the boiling point of the solvent, although the temperature is preferably from about 0°C to about 150°C, and more preferably from 60°C to 100°C.

In the Scheme 1 reaction in particular, to suppress linearity and increase the degree of branching, the reaction temperature is preferably from 60°C to 150°C, more preferably from 80°C to 150°C, and even more preferably from 80°C to 120°C.

In the first stage reaction of Scheme 2, the reaction temperature may be suitably set in the range from the melting point of the solvent used to the boiling point of the solvent, with a temperature of from about -50°C to about 50°C being preferred, a temperature of from about -20°C to about 50°C being more preferred, a temperature of from about -10°C to about 50°C being even more preferred, and a temperature of from -10°C to 10°C being still more preferred.

In the Scheme 2 method in particular, the use of a two-stage process consisting of a first step involving reaction at from -50°C to 50°C, followed by a second step involving reaction at from 60°C to 150°C is preferred.

In each of the above reactions, the ingredients may be added in any order. However, in the Scheme 1 reaction, the best method is to heat a solution containing either the cyanuric halide (18) or the diamino compound (19) and the organic solvent to a temperature of from 60°C to 150°C, and preferably from 80°C to 150°C, then add the remaining ingredient --the diamino compound (19) or the cyanuric halide (18)-- to the resulting solution at this temperature.

In this case, either ingredient may be used as the ingredient which is initially dissolved in the solvent or as the ingredient which is subsequently added, although a method wherein the cyanuric halide (18) is added to a heated solution of the diamino compound (19) is preferred.

In the Scheme 2 reactions, either ingredient may be used as the ingredient which is initially dissolved in the solvent or as the ingredient which is subsequently added, although a method wherein the diamino compound (19) is added to a cooled solution of the cyanuric halide (18) is preferred.

The subsequently added ingredient may be added neat or may be added as a solution of the ingredient dissolved in an organic solvent such as any of those mentioned above. However, taking into account the ease of operation and the controllability of the reaction, the latter approach is preferred.

Also, addition may be carried out gradually such as in a dropwise manner, or the entire amount may be added all at once in a batchwise manner.

In Scheme 1, even when the reaction is carried out in a single stage after both compounds have been mixed together in a heated state (that is, without raising the temperature in a stepwise fashion), the desired triazine ring-containing hyperbranched polymer can be obtained without gelation.

In the Scheme 1 reaction and the second stage reaction in Scheme 2, various bases which are commonly used during or after polymerization may be added.

Illustrative examples of such bases include potassium carbonate, potassium hydroxide, sodium carbonate, sodium hydroxide, sodium bicarbonate, sodium ethoxide, sodium acetate, lithium carbonate, lithium hydroxide, lithium oxide, potassium acetate, magnesium oxide, calcium oxide, barium hydroxide, trilithium phosphate, trisodium phosphate, tripotassium phosphate, cesium fluoride, aluminum oxide, ammonia, trimethylamine, triethylamine, diisopropylamine, diisopropylethylamine, N-methylpiperidine, 2,2,6,6-tetramethyl-N-methylpiperidine, pyridine, 4-dimethylaminopyridine and N-methylmorpholine.

The amount of base added per equivalent of the cyanuric halide (18) is preferably from 1 to 100 equivalents, and more preferably from 1 to 10 equivalents. These bases may be used in the form of an aqueous solution.

In the methods of both schemes, following reaction completion, the product can be easily purified by a suitable technique such as reprecipitation.

Also, in the present invention, some portion of the halogen atoms on at least one terminal triazine ring may be capped with, for example, an alkyl, aralkyl, aryl, alkylamino, alkoxysilyl-containing alkylamino, aralkylamino, arylamino, alkoxy, aralkyloxy, aryloxy or ester group.

Of these, alkylamino, alkoxysilyl-containing alkylamino, aralkylamino and arylamino groups are preferred. Alkylamino and arylamino groups are more preferred. Arylamino groups are even more preferred.

The above alkyl groups and alkoxy groups are exemplified in the same way as described earlier in the specification.

Illustrative examples of ester groups include methoxycarbonyl and ethoxycarbonyl.

Illustrative examples of aryl groups include phenyl, o-chlorophenyl, m-chlorophenyl, p-chlorophenyl, o-fluorophenyl, p-fluorophenyl, o-methoxyphenyl, p-methoxyphenyl, p-nitrophenyl, p-cyanophenyl, α-naphthyl, β-naphthyl, o-biphenylyl, m-biphenylyl, p-biphenylyl, 1-anthryl, 2-anthryl, 9-anthryl, 1-phenanthryl, 2-phenanthryl, 3-phenanthryl, 4-phenanthryl and 9-phenanthryl.

Illustrative examples of aralkyl groups include benzyl, p-methylphenylmethyl, m-methylphenylmethyl, o-ethylphenylmethyl, m-ethylphenylmethyl, p-ethylphenylmethyl, 2-propylphenylmethyl, 4-isopropylphenylmethyl, 4-isobutylphenylmethyl and α-naphthylmethyl.

Illustrative examples of alkylamino groups include methylamino, ethylamino, n-propylamino, isopropylamino, n-butylamino, isobutylamino, s-butylamino, t-butylamino, n-pentylamino, 1-methyl-n-butylamino, 2-methyl-n-butylamino, 3-methyl-n-butylamino, 1,1-dimethyl-n-propylamino, 1,2-dimethyl-n-propylamino, 2,2-dimethyl-n-propylamino, 1-ethyl-n-propylamino, n-hexylamino, 1-methyl-n-pentylamino, 2-methyl-n-pentylamino, 3-methyl-n-pentylamino, 4-methyl-n-pentylamino, 1,1-dimethyl-n-butylamino, 1,2-dimethyl-n-butylamino, 1,3-dimethyl-n-butylamino, 2,2-dimethyl-n-butylamino, 2,3-dimethyl-n-butylamino, 3,3-dimethyl-n-butylamino, 1-ethyl-n-butylamino, 2-ethyl-n-butylamino, 1,1,2-trimethyl-n-propylamino, 1,2,2-trimethyl-n-propylamino, 1-ethyl-1-methyl-n-propylamino and 1-ethyl-2-methyl-n-propylamino.

Illustrative examples of aralkylamino groups include benzylamino, methoxycarbonylphenylmethylamino, ethoxycarbonylphenylmethylamino, p-methylphenylmethylamino, m-methylphenylmethylamino, o-ethylphenylmethylamino, m-ethylphenylmethylamino, p-ethylphenylmethylamino, 2-propylphenylmethylamino, 4-isopropylphenylmethylamino, 4-isobutylphenylmethylamino, naphthylmethylamino, methoxycarbonylnaphthylmethylamino and ethoxycarbonylnaphthylmethylamino.

Illustrative examples of arylamino groups include phenylamino, methoxycarbonylphenylamino, ethoxycarbonylphenylamino, naphthylamino, methoxycarbonylnaphthylamino, ethoxycarbonylnaphthylamino, anthranylamino, pyrenylamino, biphenylamino, terphenylamino and fluorenylamino.

Alkoxysilyl-containing alkylamino groups are exemplified by monoalkoxysilyl-containing alkylamino groups, dialkoxysilyl-containing alkylamino groups and trialkoxysilyl-containing alkylamino groups.
Illustrative examples include 3-trimethoxysilylpropylamino, 3-triethoxysilylpropylamino, 3-dimethylethoxysilylpropylamino, 3-methyldiethoxysilylpropylamino, N-(2-aminoethyl)-3-dimethylmethoxysilylpropylamino, N-(2-aminoethyl)-3-methyldimethoxysilylpropylamino and N-(2-aminoethyl)-3-trimethoxysilylpropylamino.

Illustrative examples of aryloxy groups include phenoxy, naphthoxy, anthranyloxy, pyrenyloxy, biphenyloxy, terphenyloxy and fluorenyloxy.

Illustrative examples of aralkyloxy groups include benzyloxy, p-methylphenylmethyloxy, m-methylphenylmethyloxy, o-ethylphenylmethyloxy, m-ethylphenylmethyloxy, p-ethylphenylmethyloxy, 2-propylphenylmethyloxy, 4-isopropylphenylmethyloxy, 4-isobutylphenylmethyloxy and α-naphthylmethyloxy.

These groups can be easily introduced by replacing a halogen atom on a triazine ring with a compound that furnishes the corresponding substituent. For example, as shown in Scheme 3 below, by adding an aniline derivative and inducing a reaction, a hyperbranched polymer (21) having a phenylamino group on at least one end is obtained.

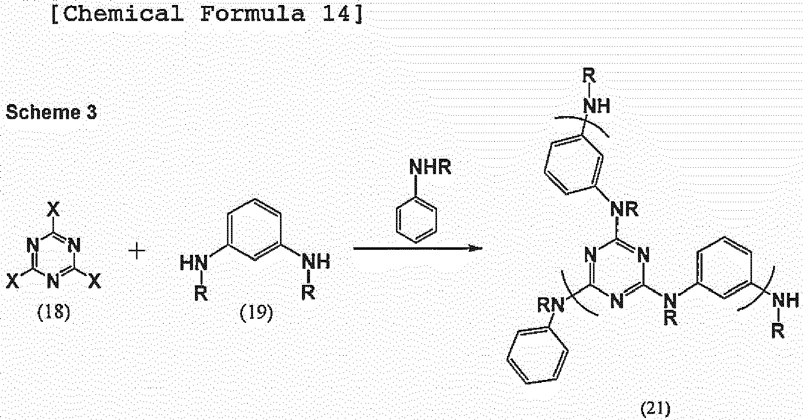

In these formulas, X and R are as defined above.

At this time, by reacting the cyanuric halide with a diaminoaryl compound while at the same time charging an organic monoamine, that is, in the presence of an organic monoamine, it is possible to obtain a flexible hyperbranched polymer having a low degree of branching in which the rigidity of the hyperbranched polymer has been diminished.

The hyperbranched polymer obtained in this way has an excellent solubility in a solvent (meaning that agglomeration is inhibited) and has an excellent crosslinkability with a crosslinking agent.

An alkyl monoamine, aralkyl monoamine or aryl monoamine may be used here as the organic monoamine.

Illustrative examples of alkyl monoamines include methylamine, ethylamine, n-propylamine, isopropylamine, n-butylamine, isobutylamine, s-butylamine, t-butylamine, n-pentylamine, 1-methyl-n-butylamine, 2-methyl-n-butylamine, 3-methyl-n-butylamine, 1,1-dimethyl-n-propylamine, 1,2-dimethyl-n-propylamine, 2,2-dimethyl-n-propylamine, 1-ethyl-n-propylamine, n-hexylamine, 1-methyl-n-pentylamine, 2-methyl-n-pentylamine, 3-methyl-n-pentylamine, 4-methyl-n-pentylamine, 1,1-dimethyl-n-butylamine, 1,2-dimethyl-n-butylamine, 1,3-dimethyl-n-butylamine, 2,2-dimethyl-n-butylamine, 2,3-dimethyl-n-butylamine, 3,3-dimethyl-n-butylamine, 1-ethyl-n-butylamine, 2-ethyl-n-butylamine, 1,1,2-trimethyl-n-propylamine, 1,2,2-trimethyl-n-propylamine, 1-ethyl-1-methyl-n-propylamine, 1-ethyl-2-methyl-n-propylamine and 2-ethylhexylamine.

Illustrative examples of aralkyl monoamines include benzylamine, p-methoxycarbonylbenzylamine, p-ethoxycarbonylbenzylamine, p-methylbenzylamine, m-methylbenzylamine and o-methoxybenzylamine.

Illustrative examples of aryl monoamines include aniline, p-methoxycarbonylaniline, p-ethoxycarbonylaniline, p-methoxyaniline, 1-naphthylamine, 2-naphthylamine, anthranylamine, 1-aminopyrene, 4-biphenylylamine, o-phenylaniline, 4-amino-p-terphenyl and 2-aminofluorene.

In this case, the amount of organic monoamine used per equivalent of the cyanuric halide is set to preferably from 0.05 to 500 equivalents, more preferably from 0.05 to 120 equivalents, and even more preferably from 0.05 to 50 equivalents. To suppress linearity and increase the degree of branching, the reaction temperature in this case is preferably from 60 to 150°C, more preferably from 80 to 150°C, and even more preferably from 80 to 120°C. However, mixing of the three ingredients --an organic monoamine, a cyanuric halide and a diaminoaryl compound-- may be carried out at a low temperature, in which case the temperature is set to preferably from about -50°C to about 50°C, more preferably from about -20°C to about 50°C, and even more preferably from -20°C to 10°C. After low-temperature charging, it is preferable to raise the temperature without interruption (i.e., in a single step) to the polymerization temperature and carry out the reaction. Alternatively, the mixing of two ingredients --a cyanuric halide and a diaminoaryl compound-- may be carried out at a low temperature, in which case the temperature is set to preferably from about -50°C to about 50°C, more preferably from about -20°C to about 50°C, and even more preferably from -20°C to 10°C. After low-temperature charging, it is preferable to add the organic monoamine, raise the temperature without interruption (i.e., in a single step) to the polymerization temperature and carry out the reaction. The reaction of the cyanuric halide with the diaminoaryl compound in the presence of such an organic monoamine may be carried out using an organic solvent like any of those mentioned above.

The crosslinking agent used in the light scattering film-forming composition of the invention is not particularly limited, provided it is a compound having substituents capable of reacting with the triazine ring-containing polymer.

Such a compound is exemplified by melamine compounds having a crosslink-forming substituent such as a methylol group or a methoxymethyl group, substituted urea compounds, compounds having a crosslink-forming substituent such as an epoxy group or an oxetane group, compounds having an isocyanate group, compounds containing a blocked isocyanate group, compounds containing an acid anhydride group, compounds having a (meth)acryl group, and phenoplast compounds. From the standpoint of heat resistance and storage stability, compounds having an epoxy group, an isocyanate group, a blocked isocyanate group or a (meth)acryl group are preferred. Compounds having an isocyanate group, and polyfunctional epoxy compounds and/or polyfunctional (meth)acrylic compounds which provide compositions that are photocurable even without the use of an initiator are especially preferred.

In cases where such a compound is used in the end group treatment of polymers, it should have at least one crosslink-forming substituent per molecule. In cases where it is used in crosslinking treatment between polymers, the compound must have at least two crosslink-forming substituents per molecule.

The polyfunctional epoxy compounds are not particularly limited, provided they have two or more epoxy groups per molecule.

Illustrative examples include tris(2,3-epoxypropyl) isocyanurate, 1,4-butanediol diglycidyl ether, 1,2-epoxy-4-(epoxyethyl)cyclohexane, glycerol triglycidyl ether, diethylene glycol diglycidyl ether, 2,6-diglycidylphenyl glycidyl ether, 1,1,3-tris[p-(2,3-epoxypropoxy)phenyl]propane, 1,2-cyclohexanedicarboxylic acid diglycidyl ester, 4,4'-methylenebis(N,N-diglycidylaniline), 3,4-epoxycyclohexylmethyl-3,4-epoxycyclohexane carboxylate, trimethylolethane triglycidyl ether, bisphenol A diglycidyl ether and pentaerythritol polyglycidyl ether.

Examples of commercial products that may be used include epoxy resins having at least two epoxy groups, such as YH-434 and YH-434L (from Tohto Kasei Co., Ltd.); epoxy resins having a cyclohexene oxide structure, such as Epolead GT-401, GT-403, GT-301 and GT-302, and also Celloxide 2021 and Celloxide 3000 (all from Daicel Chemical Industries, Ltd.); bisphenol A-type epoxy resins such as Epikote (now "jER") 1001, 1002, 1003, 1004, 1007, 1009, 1010 and 828 (all from Japan Epoxy Resin Co., Ltd.); bisphenol F-type epoxy resins such as Epikote (now "jER") 807 (Japan Epoxy Resin Co., Ltd.); phenol-novolak type epoxy resins such as Epikote (now "jER") 152 and 154 (Japan Epoxy Resin Co., Ltd.), and EPPN 201 and 202 (Nippon Kayaku Co., Ltd.); cresol-novolak type epoxy resins such as EOCN-102, EOCN-103S, EOCN-104S, EOCN-1020, EOCN-1025 and EOCN-1027 (Nippon Kayaku Co., Ltd.), and Epikote (now "jER") 180S75 (Japan Epoxy Resin Co., Ltd.); alicyclic epoxy resins such as Denacol EX-252 (Nagase ChemteX Corporation), CY175, CY177 and CY179 (Ciba-Geigy AG), Araldite CY-182, CY-192 and CY-184 (Ciba-Geigy AG), Epiclon 200 and 400 (DIC Corporation), Epikote (now "jER") 871 and 872 (Japan Epoxy Resin Co., Ltd.), and ED-5661 and ED-5662 (Celanese Coating KK); and aliphatic polyglycidyl ethers such as Denacol EX-611, EX-612, EX-614, EX-622, EX-411, EX-512, EX-522, EX-421, EX-313, EX-314 and EX-321 (Nagase ChemteX Corporation).

The polyfunctional (meth)acrylic compounds are not particularly limited, provided they have two or more (meth)acryl groups per molecule.

Illustrative examples include ethylene glycol diacrylate, ethylene glycol dimethacrylate, polyethylene glycol diacrylate, polyethylene glycol dimethacrylate, ethoxylated bisphenol A diacrylate, ethoxylated bisphenol A dimethacrylate, ethoxylated trimethylolpropane triacrylate, ethoxylated trimethylolpropane trimethacrylate, ethoxylated glycerol triacrylate, ethoxylated glycerol trimethacrylate, ethoxylated pentaerythritol tetraacrylate, ethoxylated pentaerythritol tetramethacrylate, ethoxylated dipentaerythritol hexaacrylate, polyglycerol monoethylene oxide polyacrylate, polyglycerol polyethylene glycol polyacrylate, dipentaerythritol hexaacrylate, dipentaerythritol hexamethacrylate, neopentyl glycol diacrylate, neopentyl glycol dimethacrylate, pentaerythritol triacrylate, pentaerythritol trimethacrylate, trimethylolpropane triacrylate, trimethylolpropane trimethacrylate, tricyclodecane dimethanol diacrylate, tricyclodecane dimethanol dimethacrylate, 1,6-hexanediol diacrylate and 1,6-hexanediol dimethacrylate.

The polyfunctional (meth)acrylic compound may be acquired as a commercial product, illustrative examples of which include NK Ester A-200, A-400, A-600, A-1000, A-9300 (tris[2-(acryloyloxy)ethyl] isocyanurate), A-9300-1CL, A-TMPT, UA-53H, 1G, 2G, 3G, 4G, 9G, 14G, 23G, ABE-300, A-BPE-4, A-BPE-6, A-BPE-10, A-BPE-20, A-BPE-30, BPE-80N, BPE-100N, BPE-200, BPE-500, BPE-900, BPE-1300N, A-GLY-3E, A-GLY-9E, A-GLY-20E, A-TMPT-3EO, A-TMPT-9EO, AT-20E, ATM-4E and ATM-35E (all from Shin-Nakamura Chemical Co., Ltd.); KAYARAD® DPEA-12, PEG400DA, THE-330 and RP-1040 (all from Nippon Kayaku Co., Ltd.); M-210 and M-350 (from Toagosei Co., Ltd.); KAYARAD® DPHA, NPGDA and PET30 (Nippon Kayaku Co., Ltd.); NK Ester A-DPH, A-TMPT, A-DCP, A-HD-N, TMPT, DCP, NPG and HD-N (all from Shin-Nakamura Chemical Co., Ltd.); NK Oligo U-15HA (Shin-Nakamura Chemical Co., Ltd.); and NK Polymer Vanaresin GH-1203 (Shin-Nakamura Chemical Co., Ltd.).

The acid anhydride compounds are not particularly limited, provided they are carboxylic acid anhydrides obtained by the dehydration/condensation of two molecules of carboxylic acid. Examples include those having one acid anhydride group per molecule, such as phthalic anhydride, tetrahydrophthalic anhydride, hexahydrophthalic anhydride, methyl tetrahydrophthalic anhydride, methyl hexahydrophthalic anhydride, nadic anhydride, methyl nadic anhydride, maleic anhydride, succinic anhydride, octyl succinic anhydride and dodecenyl succinic anhydride; and those having two acid anhydride groups per molecule, such 1,2,3,4-cyclobutanetetracarboxylic dianhydride, pyromellitic anhydride, 3,4-dicarboxy-1,2,3,4-tetrahydro-1-naphthalenesuccinic dianhydride, bicyclo[3.3.0]octane-2,4,6,8-tetracarboxylic dianhydride, 5-(2,5-dioxotetrahydro-3-furanyl)-3-methyl-3-cyclohexene-1,2-dicarboxylic anhydride, 1,2,3,4-butanetetracarboxylic dianhydride, 3,3',4,4'-benzophenonetetracarboxylic dianhydride, 3,3',4,4'-biphenyltetracarboxylic dianhydride, 2,2-bis(3,4-dicarboxyphenyl)hexafluoropropane dianhydride and 1,3-dimethyl-1,2,3,4-cyclobutanetetracarboxylic dianhydride.

The compounds containing blocked isocyanate groups are not particularly limited, provided they are compounds having at least two blocked isocyanate groups per molecule, i.e., isocyanate groups (-NCO) that have been blocked with suitable protecting groups, and in which, upon exposure of the compound to an elevated temperature during heat curing, the protecting groups (blocking moieties) are removed by thermal dissociation and the isocyanate groups that form as a result induce crosslinking reactions with the resin. Such compounds are exemplified by compounds having at least two groups of the following formula (which groups may be the same or may each differ) per molecule. 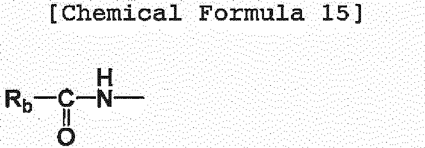 In the formula, R_{b} is an organic group on the blocking moiety.

Such a compound can be obtained by, for example, reacting a suitable blocking agent with a compound having at least two isocyanate groups per molecule.

Examples of compounds having at least two isocyanate groups per molecule include polyisocyanates such as isophorone diisocyanate, 1,6-hexamethylene diisocyanate, methylenebis(4-cyclohexyl isocyanate), and trimethylhexamethylene diisocyanate, and also dimers and trimers thereof, as well as the reaction products of these with diols, triols, diamines or triamines.

Examples of the blocking agent include alcohols such as methanol, ethanol, isopropanol, n-butanol, 2-ethoxyhexanol, 2-N,N-dimethylaminoethanol, 2-ethoxyethanol and cyclohexanol; phenols such as phenol, o-nitrophenol, p-chlorophenol, and o-, m- and p-cresol; lactams such as ε-caprolactam; oximes such as acetone oxime, methyl ethyl ketone oxime, methyl isobutyl ketone oxime, cyclohexanone oxime, acetophenone oxime and benzophenone oxime; pyrazoles such as pyrazole, 3,5-dimethylpyrazole and 3-methylpyrazole; and thiols such as dodecanethiol and benzenethiol.

The compound containing blocked isocyanate groups may also be acquired as a commercial product, examples of which include B-830, B-815N, B-842N, B-870N, B-874N, B-882N, B-7005, B7030, B-7075 and B-5010 (all from Mitsui Chemicals Polyurethanes, Inc.); Duranate® 17B-60PX, TPA-B80E, MF-B60X, MF-K60X and E402-B80T (all from Asahi Kasei Chemicals Corporation); and KarenzMOI-BM™ (Showa Denko KK).

The aminoplast compounds are not particularly limited, provided they are compounds which have at least two methoxymethylene groups per molecule. Examples include the following melamine compounds: compounds of the Cymel® series, such as hexamethoxymethylmelamine (Cymel® 303), tetrabutoxymethylglycoluril (Cymel® 1170) and tetramethoxymethylbenzoguanamine (Cymel® 1123) (all from Nihon Cytec Industries, Inc.); and compounds of the Nikalac® series, including the methylated melamine resins Nikalac® MW-30HM, MW-390, MW-100LM and MX-750LM, and the methylated urea resins Nikalac® MX-270, MX-280 and MX-290 (all from Sanwa Chemical Co., Ltd.).

The oxetane compounds are not particularly limited, provided they are compounds which have at least two oxetanyl groups per molecule. Examples include the oxetane group-bearing compounds OXT-221, OX-SQ-H and OX-SC (from Toagosei Co., Ltd.).

Phenoplast compounds are compounds which have at least two hydroxymethylene groups per molecule. Upon exposure to an elevated temperature during heat curing, crosslinking reactions proceed by way of dehydration/condensation reactions with the polymer of the invention.

Examples of phenoplast compounds include 2,6-dihydroxymethyl-4-methylphenol, 2,4-dihydroxymethyl-6-methylphenol, bis(2-hydroxy-3-hydroxymethyl-5-methylphenyl)methane, bis(4-hydroxy-3-hydroxymethyl-5-methylphenyl)methane, 2,2-bis(4-hydroxy-3,5-dihydroxymethylphenyl)propane, bis(3-formyl-4-hydroxyphenyl)methane, bis(4-hydroxy-2,5-dimethylphenyl)formylmethane and α,α-bis(4-hydroxy-2,5-dimethylphenyl)-4-formyltoluene.

The phenoplast compound may also be acquired as a commercial product, illustrative examples of which include 26DMPC, 46DMOC, DM-BIPC-F, DM-BIOC-F, TM-BIP-A, BISA-F, BI25X-DF and BI25X-TPA (all from Asahi Organic Chemicals Industry Co., Ltd.).

Of these, in terms of both an ability to suppress a decline in refractive index due to inclusion of a crosslinking agent and also rapid promotion of the curing reaction, polyfunctional (meth)acrylic compounds are preferred. In particular, owing to their excellent compatibility with triazine ring-containing polymers, polyfunctional (meth)acrylic compounds having the isocyanuric acid skeleton shown below are more preferred.

Polyfunctional (meth)acrylic compounds having such skeletons are exemplified by NK Ester A-9300 and A-9300-1CL (both of which are from Shin-Nakamura Chemical Co., Ltd.). 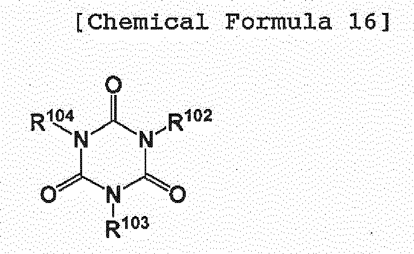 In the above formula_{,} R¹⁰² to R¹⁰⁴ are each independently a monovalent organic group having at least one terminal (meth)acryl group.

To further enhance the rate of cure and also increase the solvent resistance, acid resistance and alkali resistance of the resulting cured film, it is advantageous to use a polyfunctional (meth)acrylic compound which at 25°C is a liquid and has a viscosity of 5,000 mPa·s or less, preferably from 1 to 3,000 mPa·s, more preferably from 1 to 1,000 mPa·s, and even more preferably from 1 to 500 mPa·s (referred to below as a "low-viscosity crosslinking agent"), either singly or as a combination of two or more thereof, or in combination with the above-described polyfunctional (meth)acrylic compound having an isocyanuric acid skeleton.

Such a low-viscosity crosslinking agent too may be acquired as a commercial product. Examples include, of the above-mentioned polyfunctional (meth)acrylic compounds, crosslinking agents in which the chain lengths between (meth)acryl groups are relatively long, such as NK Ester A-GLY-3E (85 mPa·s at 25°C), A-GLY-9E (95 mPa·s at 25°C), A-GLY-20E (200 mPa·s at 25°C), A-TMPT-3EO (60 mPa·s at 25°C), A-TMPT-9EO, ATM-4E (150 mPa·s at 25°C) and ATM-35E (350 mPa·s at 25°C) (all from Shin-Nakamura Chemical Co., Ltd.).

In addition, to enhance the alkali resistance of the resulting cured film, it is preferable to use a combination of NK Ester A-GLY-20E (Shin-Nakamura Chemical Co., Ltd.) and the above-described polyfunctional (meth)acrylic compound having an isocyanuric acid skeleton.

The above crosslinking agent may be used singly or two or more may be used in combination. The amount of crosslinking agent used per 100 parts by weight of the triazine ring-containing polymer is preferably from 1 to 100 parts by weight. From the standpoint of solvent resistance, the lower limit is preferably 2 parts by weight, and more preferably 5 parts by weight. From the standpoint of control of the refractive index, the upper limit is preferably 20 parts by weight, and more preferably 15 parts by weight.

Initiators corresponding to the respective crosslinking agents may also be included in the light scattering film-forming composition of the invention. As noted above, when a polyfunctional epoxy compound and/or a polyfunctional (meth)acrylic compound are used as crosslinking agents, photocuring is promoted even without the use of an initiator, giving a cured film, although it is acceptable to use an initiator in such cases.

In cases where a polyfunctional epoxy compound is used as the crosslinking agent, a photoacid generator or a photobase generator may be used as the initiator.

The photoacid generator used may be one that is suitably selected from among known photoacid generators. For example, use may be made of onium salt derivatives such as diazonium salts, sulfonium salts and iodonium salts.

Illustrative examples include aryldiazonium salts such as phenyldiazonium hexafluorophosphate, 4-methoxyphenyldiazonium hexafluoroantimonate and 4-methylphenyldiazonium hexafluorophosphate; diaryliodonium salts such as diphenyliodonium hexafluoroantimonate, di(4-methylphenyl)iodonium hexafluorophosphate and di(4-tert-butylphenyl)iodonium hexafluorophosphate; and triarylsulfonium salts such as triphenylsulfonium hexafluoroantimonate, tris(4-methoxyphenyl)sulfonium hexafluorophosphate, diphenyl-4-thiophenoxyphenylsulfonium hexafluoroantimonate, diphenyl-4-thiophenoxyphenylsulfonium hexafluorophosphate, 4,4'-bis(diphenylsulfonio)phenylsulfide bishexafluoroantimonate, 4,4'-bis(diphenylsulfonio)phenylsulfide bishexafluorophosphate, 4,4'-bis[di(β-hydroxyethoxy)phenylsulfonio]phenylsulfide bishexafluoroantimonate, 4,4'-bis[di(β-hydroxyethoxy)phenylsulfonio]phenylsulfide bishexafluorophosphate, 4-[4'-(benzoyl)phenylthio]phenyl-di(4-fluorophenyl)sulfonium hexafluoroantimonate and 4-[4'-(benzoyl)phenylthio]phenyl-di(4-fluorophenyl)sulfonium hexafluorophosphate.

Commercial products may be used as these onium salts. Illustrative examples include San-Aid SI-60, SI-80, SI-100, SI-60L, SI-80L, SI-100L, SI-L145, SI-L150, SI-L160, SI-L110 and SI-L147 (all available from Sanshin Chemical Industry Co., Ltd.); UVI-6950, UVI-6970, UVI-6974, UVI-6990 and UVI-6992 (all available from Union Carbide); CPI-100P, CPI-100A, CPI-200K and CPI-200S (all available from San-Apro Ltd.); Adeka Optomer SP-150, SP-151, SP-170 and SP-171 (all available from Adeka Corporation); Irgacure 261 (BASF); CI-2481, CI-2624, CI-2639 and CI-2064 (Nippon Soda Co., Ltd.); CD-1010, CD-1011 and CD-1012 (Sartomer Company); DS-100, DS-101, DAM-101, DAM-102, DAM-105, DAM-201, DSM-301, NAI-100, NAI-101, NAI-105, NAI-106, SI-100, SI-101, SI-105, SI-106, PI-105, NDI-105, BENZOIN TOSYLATE, MBZ-101, MBZ-301, PYR-100, PYR-200, DNB-101, NB-101, NB-201, BBI-101, BBI-102, BBI-103 and BBI-109 (all from Midori Kagaku Co., Ltd.); PCI-061T, PCI-062T, PCI-020T and PCI-022T (all from Nippon Kayaku Co., Ltd.); and IBPF and IBCF (Sanwa Chemical Co., Ltd.).

The photobase generator used may be one selected from among known photobase generators. For example, use may be made of Co-amine complex-type, oxime carboxylic acid ester-type, carbamic acid ester-type and quaternary ammonium salt-type photobase generators.

Illustrative examples include 2-nitrobenzylcyclohexyl carbamate, triphenylmethanol, O-carbamoylhydroxylamide, O-carbamoyloxime, [[(2,6-dinitrobenzyl)oxy]carbonyl]cyclohexylamine, bis[[(2-nitrobenzyl)oxy]carbonyl]hexane-1,6-diamine, 4-(methylthiobenzoyl)-1-methyl-1--morpholinoethane, (4-morpholinobenzoyl)-1-benzyl-1-dimethylaminopropane, N-(2-nitrobenzyloxycarbonyl)pyrrolidine, hexaamminecobalt(III) tris(triphenylmethylborate), 2-benzyl-2-dimethylamino-1-(4-morpholinophenyl)butanone, 2,6-dimethyl-3,5-diacetyl-4-(2'-nitrophenyl)-1,4-dihydropyridine and 2,6-dimethyl-3,5-diacetyl-4-(2',4'-dinitrophenyl)-1,4-dihydropyridine.

A commercial product may be used as the photobase generator. Illustrative examples include TPS-OH, NBC-101 and ANC-101 (all available under these product names from Midori Kagaku Co., Ltd.).

In cases where a photoacid or photobase generator is used, the amount thereof is preferably in the range of 0.1 to 15 parts by weight, and more preferably in the range of 1 to 10 parts by weight, per 100 parts by weight of the polyfunctional epoxy compound.

Also, from 1 to 100 parts by weight of an epoxy resin curing agent may be optionally included per 100 parts by weight of the polyfunctional epoxy compound.

In cases where a polyfunctional (meth)acrylic compound is used, a photoradical initiator may also be used.

A known photoradical initiator may be suitably selected and used for this purpose. Exemplary photoradical initiators include acetophenones, benzophenones, Michler's benzoyl benzoate, amyloxime esters, oxime esters, tetramethylthiuram monosulfide and thioxanthones.

Photocleavable photoradical initiators are especially preferred. Photocleavable photoradical initiators are listed on page 159 of *Saishin UV Koka Gijutsu* [Recent UV Curing Technology] (publisher, K. Takausu; published by Gijutsu Joho Kyokai KK; 1991).

Examples of commercial photoradical initiators include those available from BASF under the trade names Irgacure 127, 184, 369, 379, 379EG, 651, 500, 754, 819, 903, 907, 784, 2959, CGI1700, CGI1750, CGI1850, CG24-61, OXE01 and OXE02, and the trade names Darocur 1116, 1173 and MBF; that available from BASF under the trade name Lucirin TPO; that available from UCB under the trade name Ubecryl P36; and those available under the trade names Esacure KIP150, KIP65LT, KIP100F, KT37, KT55, KTO46 and KIP75/B from the Fratelli Lamberti Company.

The photoradical initiator is used in the range of preferably 0.1 to 200 parts by weight, and more preferably 1 to 150 parts by weight, per 100 parts by weight of the polyfunctional (meth)acrylic compound.

The light scattering film-forming composition used in this invention additionally includes a light diffusing agent in order to increase the light diffusing properties of the resulting cured film.

The light diffusing agent is not particularly limited, the use of an organic-inorganic composite light diffusing agent, an organic light diffusing agent or an inorganic light diffusing agent being possible. Such light diffusing agents may be used singly, combinations of two or more light diffusing agents of one of these types may be used in combination, or two or more light diffusing agents of different types may be used in combination.

In addition, fine particles surface-treated with silicon dioxide, an organosilicon compound, an organometallic compound or the like may be used as the light diffusing agent.

Here, "treatment with silicon dioxide" refers to growing microparticulate silicon oxide by a known method on the surface of the particles in an inorganic fine particle-containing dispersion. "Treatment with organosilicon compound" and "treatment with an organometallic compound" refer to adding these compounds to an inorganic fine particle-containing dispersion and stirring under applied heat.

The organosilicon compound is exemplified by silane coupling agents and silanes. Illustrative examples of silane coupling agents include vinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethylditriethoxysilane, 3-glycidoxypropyltriethoxysilane, p-styryltrimethoxysilane, 3-methacryloyloxypropylmethyldimethoxysilane, 3-methacryloyloxypropyltrimethoxysilane, 3-methacryloyloxypropylmethyldiethoxysilane, 3-methacryloyloxypropyltriethoxysilane, 3-acryloyloxypropyltrimethoxysilane, N-2-(aminoethyl)-3-aminopropylmethyldimethoxysilane, N-2-(aminoethyl)-3-aminopropylmethyltrimethoxysilane, N-2-(aminoethyl)-3-aminopropylmethyltriethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, 3-chloropropyltrimethoxysilane, 3-mercaptopropylmethyldimethoxysilane, 3-mercaptopropyltrimethoxysilane, bis(triethoxysilylpropyl)tetrasulfide and 3-isocyanatopropyltriethoxysilane.

Illustrative examples of silanes include methyltrichlorosilane, dimethyldichlorosilane, trimethylchlorosilane, phenyltrichlorosilane, methyltrimethoxysilane, dimethyldimethoxysilane, phenyltrimethoxysilane, methyltriethoxysilane, dimethyldiethoxysilane, phenyltriethoxysilane, n-propyltrimethoxysilane, n-propyltriethoxysilane, hexyltrimethoxysilane, hexyltriethoxysilane, decyltrimethoxysilane, trifluoropropyltrimethoxysilane and hexamethyldisilazane.

Exemplary organometallic compounds include titanate coupling agents and aluminate coupling agents. Examples of titanate coupling agents include Plenact KR TTS, KR 46B, KR 38B, KR 138S, KR 238S, 338X, KR 44, KR 9SA, KR ET5 and KR ET (all from Ajinomoto Fine-Techno Co., Inc.). An example of an aluminum coupling agent is Plenact AL-M (Ajinomoto Fine-Techno Co., Inc.).

These organosilicon compounds and organometallic compounds are used in an amount of preferably from 2 to 100 parts by weight per 100 parts by weight of the inorganic fine particles.

Exemplary organic-inorganic composite light diffusing agents include melamine resin-silica composite particles. Such organic-inorganic composite light diffusing agents that are commercially available include, for example, the melamine resin-silica composite particles available as Optbeads® 500S (from Nissan Chemical Industries, Ltd.).

Organic-inorganic composite light diffusing agents such as these melamine resin-silica composite particles are preferably used after treatment with a surface modifying agent.

In this case, the surface modifying agent is not particularly limited, provided it is able to increase compatibility between the matrix resin and the light diffusing agent. However, taking into account the fact that the matrix resin is a triazine ring-containing polymer, the combined use of a silane coupling agent and a compound having a (meth)acryl group and an isocyanate group is preferred.

The silane coupling agent is not particularly limited, although preferred use can be made of, for example, silane coupling agents having an amino group and silane coupling agents having a thiol group. Of these, silane coupling agents having an amino group are more preferred.

Illustrative examples of silane coupling agents having an amino group include 3-aminopropyltrimethoxysilane, 3-aminopropyltriethoxysilane, 3-aminopropylmethyldimethoxysilane, 3-aminopropyldimethylmethoxysilane, 3-aminopropylmethyldiethoxysilane, 3-aminopropyldimethylethoxysilane, N-phenyl-3-aminopropyltrimethoxysilane and N-phenyl-3-aminopropyltriethoxysilane.

Illustrative examples of silane coupling agents having a thiol group include 3-mercaptopropyltrimethoxysilane, 3-mercaptopropyltriethoxysilane, mercaptomethyldimethylethoxysilane, (mercaptomethyl)methyldiethoxysilane and 3-mercaptopropylmethyldimethoxysilane.

The compound having a (meth)acryl group and an isocyanate group is not particularly limited, so long as it is a compound having both of these functional groups.

Illustrative examples include 2-isocyanatoethyl acrylate, 2-isocyanatoethyl methacrylate, 1,1-(bisacryloyloxymethyl)ethyl isocyanate, and compounds in which these isocyanate groups are blocked.

Examples of commercially available compounds of this type include Karenz AOI® (2-isocyanatoethyl acrylate), Karenz MOI® (2-isocyanatoethyl methacrylate), Karenz BEI® (1,1-(bisacryloyloxymethyl)ethyl isocyanate), Karenz MOI-BM® (2-(O-[1'-methylpropylideneamino]carboxyamino)ethyl methacrylate, a blocked isocyanate compound of Karenz MOI), Karenz MOI-BP® (2-[(3,5-dimethylpyrazolyl)carbonylamino]ethyl methacrylate, a blocked isocyanate compound of Karenz MOI) and Karenz MOI-EG® (all available from Showa Denko K.K.).

The surface modifying method is not particularly limited. Suitable use may be made of a hitherto known method, such as the method of mixing together an organic-inorganic composite light diffusing agent, a silane coupling agent and a compound having both a (meth)acryl group and an isocyanate group in a suitable solvent, and stirring under applied heat.

In this case, the silane coupling agent and the compound having a (meth)acryl group and an isocyanate group are used in a ratio such that the molar ratio of amino groups or thiol groups (referred to below as "active hydrogen groups") in the silane coupling agent to isocyanate groups (referred to below as "NCO groups") in the compound having both a (meth)acryl group and an isocyanate group, expressed as "active hydrogen groups/NCO," is in the range of preferably 0.1/10 to 15/10, and is most preferably 1/1.

The amount of surface treatment agent used with respect to the light diffusing agent, expressed as the total amount of surface treatment agent per 100 parts by weight of the light diffusing agent, is preferably from 1 to 150 parts by weight, and more preferably from 10 to 100 parts by weight.

The solvent may be any having an ability to disperse particles. Illustrative examples solvents include water, toluene, p-xylene, o-xylene, m-xylene, ethylbenzene, styrene, ethylene glycol dimethyl ether, propylene glycol monomethyl ether, ethylene glycol monomethyl ether, propylene glycol, propylene glycol monoethyl ether, ethylene glycol monoethyl ether, ethylene glycol monoisopropyl ether, ethylene glycol methyl ether acetate, propylene glycol monomethyl ether acetate, ethylene glycol ethyl ether acetate, diethylene glycol dimethyl ether, propylene glycol monobutyl ether, ethylene glycol monobutyl ether, diethylene glycol diethyl ether, dipropylene glycol monomethyl ether, diethylene glycol monomethyl ether, dipropylene glycol monoethyl ether, diethylene glycol monoethyl ether, triethylene glycol dimethyl ether, diethylene glycol monoethyl ether acetate, diethylene glycol, 1-octanol, ethylene glycol, hexylene glycol, trimethylene glycol, 1-methoxy-2-butanol, cyclohexanol, diacetone alcohol, furfuryl alcohol, tetrahydrofurfuryl alcohol, propylene glycol, benzyl alcohol, 1,3-butanediol, 1,4-butanediol, 2,3-butanediol, γ-butyrolactone, acetone, methyl ethyl ketone, methyl isopropyl ketone, diethyl ketone, methyl isobutyl ketone, methyl n-butyl ketone, cyclopentanone, cyclohexanone, ethyl acetate, isopropyl acetate, n-propyl acetate, isobutyl acetate, n-butyl acetate, ethyl lactate, methanol, ethanol, isopropanol, tert-butanol, allyl alcohol, n-propanol, 2-methyl-2-butanol, isobutanol, n-butanol, 2-methyl-1-butanol, 1-pentanol, 2-methyl-1-pentanol, 2-ethylhexanol, 1-methoxy-2-propanol, tetrahydrofuran, 1,4-dioxane, N,N-dimethylformamide, N,N-dimethylacetamide (DMAc), N-methylpyrrolidone, 1,3-dimethyl-2-imidazolidinone, dimethylsulfoxide and N-cyclohexyl-2-pyrrolidinone. These may be used singly or two or more may be used in combination.

Following surface treatment, the surface-treated light diffusing agent may be removed and used or may be used directly as a dispersion. When used as a dispersion, the solids concentration therein is not particularly limited, but may be set to from about 0.1 wt % to about 50 wt %.

During such surface modification, in order to further increase the dispersibility of the resulting surface-modified light diffusing agent, the light diffusing agent prior to surface modification may be dispersed beforehand in the above-described solvent so as to prepare a dispersion, and surface modification carried out by adding the surface modifying agent to this dispersion.

The dispersion treatment method is not particularly limited. For example, use may be made of ultrasonic treatment or wet jet mill treatment.

The solids concentration of the dispersion in this case is not particularly limited, and may be set to from about 0.1 wt % to about 50 wt %.

Examples of organic light diffusing agents include crosslinked polymethyl methacrylate (PMMA) particles, crosslinked polymethyl acrylate particles, crosslinked polystyrene particles, crosslinked styrene-acrylic copolymer particles, melamine-formaldehyde particles, silicone resin particles, silica-acrylic composite particles, nylon particles, benzoguanamine-formaldehyde particles, benzoguanamine-melamine-formaldehyde particles, fluoropolymer particles, epoxy resin particles, polyphenylene sulfide resin particles, polyethersulfone resin particles, polyacrylonitrile particles and polyurethane particles. Illustrative examples of commercial products of such organic light diffusing agents include the following crosslinked PMMA particles: MX-150 (from Soken Chemical & Engineering Co., Ltd.), the Techpolymer SSX Series (Sekisui Plastics Co., Ltd.) and the Taftic® FH-S Series (Toyobo Co., Ltd.); crosslinked styrene-acrylic hollow particles (NANOTEX, available from JSR Corporation), silicone resin particles of the Tospearl Series (from Momentive) and the KMP Series (Shin-Etsu Chemical Co., Ltd.), polystyrene and polymethacrylic ester particles of the Ganzpearl Series (Gantz Kasei KK), Soliostar RA and SP (silica-acrylic composite particles available from Nippon Shokubai Co., Ltd.), Amilan (nylon particles from Toray Industries, Inc.), Epostar MS, M05 and L15 (benzoguanamine-formaldehyde particles from Nippon Shokubai Co., Ltd.), Epostar M30 (benzoguanamine-melamine-formaldehyde particles from Nippon Shokubai Co., Ltd.), Fluon PTFE dispersions of fluoropolymer particles (Asahi Glass Co., Ltd.), Toraypearl EP (epoxy resin particles from Toray Industries, Inc.), Toraypearl PPS (polyphenylene sulfide resin particles from Toray Industries, Inc.), Toraypearl PES (polyethersulfone resin particles from Toray Industries, Inc.), Taftic F Series F-120 (polyacrylonitrile particles from Toyobo Co., Ltd.), and Art Pearl crosslinked urethane beads MM (polyurethane particles from Negami Chemical Industrial Co., Ltd.).

Examples of inorganic light diffusing agents include, but are not limited to, calcium carbonate (CaCO₃), titanium oxide (TiO₂), barium sulfate (BaSO₄), aluminum hydroxide (Al(OH)₃), silica (SiO₂) and talc. From the standpoint of further increasing the light diffusing properties of the resulting cured film, titanium oxide (TiO₂) and agglomerated silica particles are preferred, with non-agglomerating titanium oxide (TiO₂) being more preferred. Of these, inorganic light diffusing agents that have been surface treated with a (meth)acryloxy group-containing trialkoxysilane surface modifying agent such as 3-acryloxypropyltrimethoxysilane, 3-methacryloxypropyltrimethoxysilane, 3-acryloxypropyltriethoxysilane, 3-methacryloxypropyltriethoxysilane, 3-acryloxypropylmethyldimethoxysilane, 3-methacryloxypropylmethyldimethoxysilane, 3-acryloxypropyldimethylmethoxysilane, 3-methacryloxypropyldimethylmethoxysilane, 3-acryloxypropylmethyldiethoxysilane, 3-methacryloxypropylmethyldiethoxysilane, 3-acryloxypropyldimethylethoxysilane and 3-methacryloxypropyldimethylethoxysilane are especially preferred.

These surface modifying agents are used in an amount which is not particularly limited, although use in an amount of about 1.0 to about 5.0 molecules of surface modifying agent per square nanometer of surface on the titanium oxide (TiO₂) or silica particles is preferred.

The surface modification method is not particularly limited. A method known to the art may be suitably used.

From the standpoint of increasing the dispersibility in the triazine ring-containing polymer serving as the matrix resin, the titanium oxide (TiO₂) or agglomerated silica particles are preferably used in the form of an organic solvent dispersion. In this case, the organic solvent, although not particularly limited, is exemplified by the organic solvents mentioned above as examples of solvents for surface treating the organic-inorganic composite light diffusing agent. Preferred solvents for preparing a dispersion of titanium oxide include ketone solvents such as acetone, methyl ethyl ketone, methyl isopropyl ketone, diethyl ketone, methyl isobutyl ketone, methyl n-butyl ketone and cyclohexanone. Preferred solvents for preparing a dispersion of agglomerated silica include glycol ether solvents such as ethylene glycol dimethyl ether, propylene glycol monomethyl ether, ethylene glycol monomethyl ether, propylene glycol, propylene glycol monoethyl ether, ethylene glycol monoethyl ether, ethylene glycol monoisopropyl ether, ethylene glycol methyl ether acetate, propylene glycol monomethyl ether acetate, ethylene glycol ethyl ether acetate, diethylene glycol dimethyl ether, propylene glycol monobutyl ether, ethylene glycol monobutyl ether, diethylene glycol diethyl ether, dipropylene glycol monomethyl ether, diethylene glycol monomethyl ether, dipropylene glycol monoethyl ether, diethylene glycol monoethyl ether, triethylene glycol dimethyl ether and diethylene glycol monoethyl ether acetate.

The solids concentration is not particularly limited, and may be set to from about 0.1 wt % to about 50 wt %.

Examples of commercially available agglomerated silica particles include Lightstar LA-S26 (Nissan Chemical Industries, Ltd.) and Lightstar LA-OS20PGM (Nissan Chemical Industries, Ltd.), which are alkaline dispersions of agglomerated silica particles. These may be used after solvent substitution by a suitable method.

Of the various above light dispersing agents, in terms of increasing the light diffusing properties of the resulting cured film, titanium oxide (TiO₂) is preferred. Moreover, in terms of increasing the dispersion stability of the titanium oxide dispersion and increasing the ease of operations such as filterability, non-agglomerated titanium oxide (TiO₂) that has been surface treated with a (meth)acryloxy group-containing trialkoxysilane surface modifying agent is most preferred.

The average particle size of the light diffusing agent is not particularly limited, although from the standpoint of further increasing the dispersibility, making the resulting cured film thinner and further increasing the planarity of the cured film, the average particle size is preferably not more than 3 µm, more preferably not more than 2 µm, and even more preferably not more than 1 µm. From the standpoint of having the resulting cured film exhibit sufficient light diffusing properties, the average particle size is preferably at least 100 nm, more preferably at least 150 nm, and even more preferably at least 200 nm.

The average particle size (µm) is the 50% volume diameter (median diameter) obtained by measurement using a laser diffraction scattering method based on the Mie theory, and can be measured with, for example, a Mastersizer® 2000 from Malvern Instruments.

The amount of light diffusing agent used is not particularly limited. However, in terms of further increasing the light scattering efficiency of the resulting cured film, the lower limit per 100 parts by weight of the triazine ring-containing polymer is preferably 1 part by weight, more preferably 5 parts by weight, and even more preferably 30 parts by weight. In terms of suppressing a decrease in the light transmittance of the cured film and suppressing a decline in the film-forming properties, the upper limit is preferably 250 parts by weight, more preferably 200 parts by weight, and even more preferably 150 parts by weight.

Various solvents may be added to the light scattering film-forming composition of the invention and used to dissolve the triazine ring-containing polymer.

In such cases, the solvent may be the same as or different from the solvent used during polymerization. The solvent is not particularly limited; any one or plurality of solvents may be selected and used for this purpose, so long as compatibility with the polymer is not lost.

Such solvents are exemplified by the same as those mentioned above as solvents used for surface modification of the light diffusing agent.

The concentration of solids in the light scattering film-forming composition is not particularly limited, so long as it is in a range that does not affect the storage stability, and may be suitably set in accordance with the target film thickness. Specifically, from the standpoint of solubility and storage stability, the solids concentration is preferably from 0.1 to 50 wt %, and more preferably from 0.1 to 40 wt %.

Ingredients other than the triazine ring-containing polymer, crosslinking agent, light diffusing agent and solvent may also be included in the light scattering film-forming compositions used in this invention, provided that doing so does not detract from the advantageous effects of the invention. Examples of such other ingredients include leveling agents and surfactants.

Illustrative examples of surfactants include the following nonionic surfactants: polyoxyethylene alkyl ethers such as polyoxyethylene lauryl ether, polyoxyethylene stearyl ether, polyoxyethylene cetyl ether and polyoxyethylene oleyl ether; polyoxyethylene alkylaryl ethers such as polyoxyethylene octylphenol ether and polyoxyethylene nonylphenol ether; polyoxyethylene-polyoxypropylene block copolymers; sorbitan fatty acid esters such as sorbitan monolaurate, sorbitan monopalmitate, sorbitan monostearate, sorbitan monooleate, sorbitan trioleate and sorbitan tristearate; and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate and polyoxyethylene sorbitan tristearate; and additionally include fluorosurfactants such as those available under the trade names Eftop EF301, EF303 and EF352 (from Mitsubishi Materials Electronic Chemicals Co., Ltd. (formerly Jemco Inc.)), Megafac F171, F173, R-08, R-30, R-40, F-553, F-554, RS-75 and RS-72-K (DIC Corporation), Fluorad FC430 and FC431 (Sumitomo 3M, Ltd.), AsahiGuard AG710 and Surflon S-382, SC101, SC102, SC103, SC104, SC105 and SC106 (Asahi Glass Co., Ltd.); and also the organosiloxane polymers KP341 (Shin-Etsu Chemical Co., Ltd.) and BYK-302, BYK-307, BYK-322, BYK-323, BYK-330, BYK-333, BYK-370, BYK-375 and BYK-378 (BYK-Chemie Japan KK).

These surfactants may be used singly or two or more may be used in combination. The amount of surfactant used per 100 parts by weight of the triazine ring-containing polymer is preferably from 0.0001 to 5 parts by weight, more preferably from 0.001 to 1 part by weight, and even more preferably from 0.01 to 0.5 part by weight.

The other ingredients mentioned above may be added in any step during preparation of the composition used in this invention.

The light scattering film-forming composition may be formed into the desired cured film by applying the composition onto a base material, optionally heating to evaporate off the solvent, and subsequently heating or carrying out light exposure to cure the composition.

Any suitable method may be used for applying the composition, such as spin coating, dipping, flow coating, inkjet printing, spray coating, bar coating, gravure coating, slit coating, roll coating, transfer printing, brush coating, blade coating, air knife coating and screen printing.

Illustrative examples of the base material include silicon, indium-tin oxide (ITO)-coated glass, indium zinc oxide (IZO)-coated glass, polyethylene terephthalate (PET), plastic, glass, quartz and ceramic. Use can also be made of a flexible base material having pliability.

The bake temperature for evaporating off the solvent is not particularly limited. The bake may be carried out at, for example, from 40 to 400°C.

The bake process is not particularly limited. For example, evaporation may be effected using a hot plate or an oven, such evaporation being carried out under a suitable atmosphere, such as in open air, in nitrogen or another inert gas, or in a vacuum.

With regard to the bake temperature and time, conditions which are compatible with the processing steps for the target electronic device should be selected. Bake conditions should be selected in such a way that the physical values of the resulting film conform to the required characteristics of the electronic device.

The conditions in cases where exposure to light is carried out are also not particularly limited. For example, an exposure energy and time which are suitable for the triazine ring-containing polymer and crosslinking agent that are used may be employed.

Because the cured film of the invention that has been thus obtained is able to achieve a high heat resistance, high transparency, high refractive index, high solubility and low volume shrinkage, it can be advantageously used as a component in the fabrication of electronic devices such as liquid-crystal displays, organic EL devices (organic EL displays and organic EL lighting), optical semiconductor (LED) devices, solid-state image sensors, organic thin-film solar cells, dye-sensitized solar cells and organic thin-film transistors (TFTs). In particular, the cured film has an excellent light diffusing ability, and can therefore be advantageously used as a material for a light scattering layer (light extraction layer) in organic EL devices and LEDs.

To further increase the planarity of the resulting cured film, a composition which, aside from excluding the light diffusing agent, is the same as the above-described light scattering film-forming composition may be rendered into a planarizing material and, by using this material, a planarizing film may be additionally deposited on the cured film (light scattering film).

Specific examples of the triazine ring-containing polymer, crosslinking agent, etc. in this planarizing material, as well as the amounts in which these ingredients are included and the film-forming method, are as described above.

By using the above-described cured film as a light extraction film for an organic EL device, it is possible to obtain an organic EL device having a good current efficiency (light extraction efficiency).

In cases where the cured film is to be used as a light extraction film, an electrode substrate having the cured film is produced and various functional layers are successively formed on top thereof to fabricate an organic EL device.

By way of illustration, using the above-described light scattering film-forming composition, a cured film is formed by the above-described method on a substrate of glass or the like, and an ITO or IZO film that is to serve as the positive electrode material is formed thereon in the usual manner by RF sputtering or the like, thereby fabricating a positive electrode substrate.

A small molecule-based organic electroluminescence (OLED) device or a polymer molecule-based organic electroluminescence (PLED) device may be fabricated using this positive electrode substrate.

Examples of the materials and methods used to fabricate OLED devices include, but are not limited to, those mentioned below.

The electrode substrate to be used is preferably cleaned by first carrying out liquid cleaning with a cleaning agent, alcohol, pure water or the like. For a positive electrode substrate, the substrate is preferably surface-treated by UV ozone treatment, oxygen-plasma treatment or the like just prior to use. However, when the positive electrode material is composed primarily of an organic material, surface treatment need not be carried out.

A hole injection layer, a hole transport layer, an emissive layer, an electron transport layer, an electron transport layer/hole-blocking layer and cathode metal are formed on the electrode to give an OLED device. Where necessary, an electron-blocking layer may be provided between the emissive layer and the hole transport layer.

Illustrative examples of anode materials include transparent electrodes such as indium-tin oxide (ITO) and indium-zinc oxide (IZO), and metal anodes made of a metal such as aluminum or an alloy of such a metal. An anode material on which planarizing treatment has been carried out is preferred. Use can also be made of polythiophene derivatives and polyaniline derivatives having high charge transportability.

Examples of other metals making up the metal anode include, but are not limited to, scandium, titanium, vanadium, chromium, manganese, iron, cobalt, nickel, copper, zinc, gallium, yttrium, zirconium, niobium, molybdenum, ruthenium, rhodium, palladium, cadmium, indium, scandium, lanthanum, cerium, praseodymium, neodymium, promethium, samarium, europium, gadolinium, terbium, dysprosium, holmium, erbium, thulium, ytterbium, hafnium, thallium, tungsten, rhenium, osmium, iridium, platinum, gold, titanium, lead, bismuth, and alloys thereof.

Hole injection layer and hole transport layer-forming materials are exemplified by hole-transporting low-molecular-weight materials, including triarylamines such as (triphenylamine) dimer derivatives, [(triphenylamine) dimer] spirodimer, N,N'-bis(naphthalen-1-yl)-N,N'-bis(phenyl)benzidine (α-NPD), N,N'-bis(naphthalen-2-yl)-N,N'-bis(phenyl)benzidine, N,N'-bis(3-methylphenyl)-N,N'-bis(phenyl)benzidine, N,N'-bis(3-methylphenyl)-N,N'-bis(phenyl)-9,9-spirobifluorene, N,N'-bis(naphthalen-1-yl)-N,N'-bis(phenyl)-9,9-spirobifluorene, N,N'-bis(3-methylphenyl)-N,N'-bis(phenyl)-9,9-dimethylfluorene, N,N'-bis(naphthalen-1-yl)-N,N'-bis(phenyl)-9,9-dimethylfluorene, N,N'-bis(3-methylphenyl)-N,N'-bis(phenyl)-9,9-diphenylfluorene, N,N'-bis(naphthalen-1-yl)-N,N'-bis(phenyl)-9,9-diphenylfluorene, N,N'-bis(naphthalen-1-yl)-N,N'-bis(phenyl)-2,2'-dimethylbenzidine, 2,2',7,7'-tetrakis(N,N-diphenylamino)-9,9-spirobifluorene, 9,9-bis[4-(N,N-bisbiphenyl-4-ylamino)phenyl]-9H-fluorene, 9,9-bis[4-(N,N-bisnaphthalen-2-ylamino)phenyl]-9H-fluorene, 9,9-bis[4-(N-naphthalen-1-yl-N-phenylamino)phenyl]-9H-fluorene, 2,2',7,7'-tetrakis[N-naphthalenyl(phenyl)amino]-9,9-spirobifluorene, N,N'-bis(phenanthren-9-yl)-N,N'-bis(phenyl)benzidine, 2,2'-bis[N,N-bis(biphenyl-4-yl)amino]-9,9-spirobifluorene, 2,2'-bis(N,N-diphenylamino)-9,9-spirobifluorene, di[4-(N,N-di(p-tolyl)amino)phenyl]cyclohexane, 2,2',7,7'-tetra(N,N-di(p-tolyl))amino-9,9-spirobifluorene, N,N,N',N'-tetranaphthalen-2-ylbenzidine, N,N,N',N'-tetra(3-methylphenyl)-3,3'-dimethylbenzidine, N,N'-di(naphthalenyl)-N,N'-di(naphthalen-2-yl)benzidine, N,N,N',N'-tetra(naphthalenyl)benzidine, N,N'-di(naphthalen-2-yl)-N,N'-diphenylbenzidine-1-4-diamine, N¹,N⁴-diphenyl-N¹,N⁴-di(m-tolyl)benzene-1,4-diamine, N²,N²,N⁶,N⁶-tetraphenylnaphthalene-2,6-diamine, tris(4-(quinolin-8-yl)phenyl)amine, 2,2'-bis(3-(N,N-di(p-tolyl)amino)phenyl)biphenyl, 4,4',4"-tris[3-methylphenyl(phenyl)amino]triphenylamine (m-MTDATA) and 4,4',4"-tris[1-naphthyl(phenyl)amino]triphenylamine (1-TNATA); and oligothiophenes such as 5,5"-bis-{4-[bis(4-methylphenyl)amino]phenyl}-2,2':5',2"-terthiophene (BMA-3T).

Specific examples of emissive layer-forming materials include tris(8-quinolinolate) aluminum(III) (Alq₃), bis(8-quinolinolate) zinc(II) (Znq₂), bis(2-methyl-8-quinolinolate)-4-(p-phenylphenolate) aluminum(III) (BAlq), 4,4'-bis(2,2-diphenylvinyl)biphenyl, 9,10-di(naphthalen-2-yl)anthracene, 2-t-butyl-9,10-di(naphthalen-2-yl)anthracene, 2,7-bis[9,9-di(4-methylphenyl)fluoren-2-yl]-9,9-di(4-methylphenyl)fluorene, 2-methyl-9,10-bis(naphthalen-2-yl)anthracene, 2-(9,9-spirobifluoren-2-yl)-9,9-spirobifluorene, 2,7-bis(9,9-spirobifluoren-2-yl)-9,9-spirobifluorene, 2-[9,9-di(4-methylphenyl)fluoren-2-yl]-9,9-di(4-methylphenyl)fluorene, 2,2'-dipyrenyl-9,9-spirobifluorene, 1,3,5-tris(pyren-1-yl)benzene, 9,9-bis[4-(pyrenyl)phenyl]-9H-fluorene, 2,2'-bi(9,10-diphenylanthracene), 2,7-dipyrenyl-9,9-spirobifluorene, 1,4-di(pyren-1-yl)benzene, 1,3-di(pyren-1-yl)benzene, 6,13-di(biphenyl-4-yl)pentacene, 3,9-di(naphthalen-2-yl)perylene, 3,10-di(naphthalen-2-yl)perylene, tris[4-(pyrenyl)phenyl]amine, 10,10'-di(biphenyl-4-yl)-9,9'-bianthracene, N,N'-di(naphthalen-1-yl)-N,N'-diphenyl[1,1':4',1":4",1"'-quaterphenyl]-4,4"'-diamine, 4,4'-di[10-(naphthalen-1-yl)anthracen-9-yl]biphenyl, dibenzo{[f,f']-4,4',7,7'-tetraphenyl}diindeno[1,2,3-cd:1',2',3'-lm]perylene, 1-(7-(9,9'-bianthracen-10-yl)-9,9-dimethyl-9H-fluoren-2-yl)pyrene, 1-(7-(9,9'-bianthracen-10-yl)-9,9-dihexyl-9H-fluoren-2-yl)pyrene, 1,3-bis(carbazol-9-yl)benzene, 1,3,5-tris(carbazol-9-yl)benzene, 4,4',4"-tris(carbazol-9-yl)triphenylamine, 4,4'-bis(carbazol-9-yl)biphenyl (CBP), 4,4'-bis(carbazol-9-yl)-2,2'-dimethylbiphenyl, 2,7-bis(carbazol-9-yl)-9,9-dimethylfluorene, 2,2',7,7'-tetrakis(carbazol-9-yl)-9,9-spirobifluorene, 2,7-bis(carbazol-9-yl)-9,9-di(p-tolyl)fluorene, 9,9-bis[4-(carbazol-9-yl)phenyl]fluorene, 2,7-bis(carbazol-9-yl)-9,9-spirobifluorene, 1,4-bis(triphenylsilyl)benzene, 1,3-bis(triphenylsilyl)benzene, bis(4-N,N-diethylamino-2-methylphenyl)-4-methylphenylmethane, 2,7-bis(carbazol-9-yl)-9,9-dioctylfluorene, 4,4"-di(triphenylsilyl)-p-terphenyl, 4,4'-di(triphenylsilyl)biphenyl, 9-(4-t-butylphenyl)-3,6-bis(triphenylsilyl)-9H-carbazole, 9-(4-t-butylphenyl)-3,6-ditrityl-9H-carbazole, 9-(4-t-butylphenyl)-3,6-bis(9-(4-methoxyphenyl)-9H-fluoren-9-yl)-9H-carbazole, 2,6-bis(3-(9H-carbazol-9-yl)phenyl)pyridine, triphenyl(4-(9-phenyl-9H-fluoren-9-yl)phenyl)silane, 9,9-dimethyl-N,N-diphenyl-7-(4-(1-phenyl-1H-benzo[d]imidazol-2-yl)phenyl-9H-fluoren-2-amine, 3,5-bis(3-(9H-carbazol-9-yl)phenyl)pyridine, 9,9-spirobifluoren-2-yldiphenylphosphine oxide, 9,9'-(5-triphenylsilyl)-1,3-phenylene)bis(9H-carbazole), 3-(2,7-bis(diphenylphosphoryl)-9-phenyl-9H-fluoren-9-yl)-9-phenyl-9H-carbazole, 4,4,8,8,12,12-hexa(p-tolyl)-4H-8H-12H-12C-azadibenzo[cd,mn]-pyrene, 4,7-di(9H-carbazol-9-yl)-1,10-phenanthroline, 2,2'-bis(4-(carbazol-9-yl)phenyl)biphenyl, 2,8-bis(diphenylphosphoryl)dibenzo[b,d]thiophene, bis(2-methylphenyl)diphenylsilane, bis[3,5-di(9H-carbazol-9-yl)phenyl]diphenylsilane, 3,6-bis(carbazol-9-yl)-9-(2-ethylhexyl)-9H-carbazole, 3-(diphenylphosphoryl)-9-(4-(diphenylphosphoryl)phenyl)-9H-carbazole and 3,6-bis[(3,5-diphenyl)phenyl]-9-phenylcarbazole. It is also possible to form the emissive layer by co-vapor deposition of any of these materials with a light-emitting dopant.

Specific examples of light-emitting dopants include 3-(2-benzothiazolyl)-7-(diethylamino)coumarin, 2,3,6,7-tetrahydro-1,1,7,7-tetramethyl-1H,5H,11H-10-(2-benzothiazolyl)quinolidino[9,9a,1gh]coumarin, quinacridone, N,N'-dimethylquinacridone, tris(2-phenylpyridine) iridium(III) {Tr(ppy)₃), bis(2-phenylpyridine)(acetylacetonate) iridium(III) (Ir(ppy)₂(acac)), tris[2-(p-tolyl)pyridine] iridium(III) (Ir(mppy)₃), 9,10-bis[N,N-di(p-tolyl)amino]anthracene, 9,10-bis[phenyl(m-tolyl)amino]anthracene, bis[2-(2-hydroxyphenyl)benzothiazolate] zinc(II), N10 ,N10 ,N10' ,N10'-tetra(p-tolyl)-9,9'-bianthracene-10,10'-diamine, N10 ,N10 ,N10' ,N10'-tetraphenyl-9,9'-bianthracene-10,10'-diamine, N¹⁰,N^{10'}-diphenyl-N¹⁰,N^{10'}-dinaphthalenyl-9,9'-bianthracene-10,10'-diamino, 4,4'-bis(9-ethyl-3-carbazovinylene)-1,1'-biphenyl, perylene, 2,5,8,11-tetra-t-butylperylene, 1,4-bis[2-(3-N-ethylcarbazolyl)vinyl]benzene, 4,4'-bis[4-(di-p-tolylamino)styryl]biphenyl, 4-(di-p-tolylamino)-4'-[(di-p-tolylamino)styryl]stilbene, bis[3,5-difluoro-2-(2-pyridyl)phenyl-(2-carboxypyridyl)] iridium(III), 4,4'-bis[4-(diphenylamino)styryl]biphenyl, bis(2,4-difluorophenylpyridinato)tetrakis(1-pyrazolyl)borate iridium(III), N,N'-bis(naphthalen-2-yl)-N,N'-bis(phenyl)tris(9,9-dimethylfluorenylene), 2,7-bis{2-[phenyl(m-tolyl)amino]-9,9-dimethylfluoren-7-yl}-9,9-dimethylfluorene, N-(4-((E)-2-(6((E)-4-(diphenylamlno)styryl)naphthalen-2-yl)vinyl)phenyl)-N-phenylbenzenamine, fac-iridium(III) tris(1-phenyl-3-methylbenzimidazolin-2-ylidene-C,C^{2'}), mer-iridium(III) tris(1-phenyl-3-methylbenzimidazolin-2-ylidene-C,C^{2'}), 2,7-bis[4-(diphenylamino)styryl]-9,9-spirobifluorene, 6-methyl-2-(4-(9-(4-(6-methylbenzo[d]thiazol-2-yl)phenyl)-anthracen-10-yl)phenyl)benzold]thiazole, 1,4-di[4-(N,N-diphenyl)amino]styrylbenzene, 1,4-bis(4-(9H-carbazol-9-yl)styryl)benzene, (E)-6-(4-(diphenylamino)styryl)-N,N-diphenylnaphthalen-2-amine, bis(2,4-difluorophenylpyridinato)(5-(pyridin-2-yl)-1H-tetrazolate) iridium(III), bis(3-trifluoromethyl-5-(2-pyridyl)pyrazole)((2,4-difluoro-benzyl)diphenylphosphinate) iridium(III), bis(3-trifluoromethyl-5-(2-pyridyl)pyrazolate)(benzyl-diphenylphosphinate) iridium(III), bis(1-(2,4-difluorobenzyl)-3-methylbenzimidazolium)(3-(trifluoromethyl)-5-(2-pyridyl)-1,2,4-triazolate) iridium(III), bis(3-trifluoromethyl-5-(2-pyridyl)pyrazolate)(4',6'-difluorophenylpyridinate) iridium(III), bis(4',6'-difluorophenylpyridinato)(3,5-bis(trifluoromethyl)-2-(2'-pyridyl)pyrrolate) iridium(III), bis(4',6'-difluorophenylpyridinato)(3-(trifluoromethyl)-5-(2-pyridyl)-1,2,4-triazolate) iridium (III), (Z)-6-mesityl-N-(6-mesitylquinolin-2(1H)-ylidene)quinoline-2-amine-BF₂, (E)-2-(2-(4-(dimethylamino)styryl)-6-methyl-4H-pyran-4-ylidene)malononitrile, 4-(dicyanomethylene)-2-methyl-6-julolidyl-9-enyl-4-H-pyran, 4-(dicyanomethylene)-2-methyl-6-(1,1,7,7-tetramethyl-julolidyl-9-enyl)-4H-pyran, 4-(dicyanomethylene)-2-t-butyl-6-(1,1,7,7-tetramethyl-julolidin-4-ylvinyl)-4H-pyran, tris(dibenzoylmethane)phenanthroline europium(III), 5,6,11,12-tetraphenylnaphthacene, bis(2-benzo[b]thiophen-2-yl-pyridine)(acetylacetonate) iridium(III), tris(1-phenylisoquinoline) iridium(III), bis(1-phenylisoquinoline)(acetylacetonate) iridium(III), bis[1-(9,9-dimethyl-9H-fluoren-2-yl)isoquinoline]-(acetylacetonate) iridium(III), bis[2-(9,9-dimethyl-9H-fluoren-2-yl)quinoline]-(acetylacetonate) iridium(III), tris[4,4'-di-t-butyl-(2,2')-bipyridine] ruthenium(III)·bis(hexafluorophosphate), tris(2-phenylquinoline) iridium(III), bis(2-phenylquinoline)(acetylacetonate) iridium(III), 2,8-di-t-butyl-5,11-bis(4-t-butylphenyl)-6,12-diphenyltetracene, bis(2-phenylbenzothiazolate)(acetylacetonate) iridium(III), platinum 5,10,15,20-tetraphenyltetrabenzoporphyrin, osmium(II) bis(3-trifluoromethyl-5-(2-pyridine)pyrazolate)-dimethylphenylphosphine, osmium(II) bis(3-trifluoromethyl)-5-(4-t-butylpyridyl)-1,2,4-triazolate)diphenylmethylphosphine, osmium(II) bis(3-(trifluoromethyl)-5-(2-pyridyl)-1,2,4-triazole)dimethylphenylphosphine, osmium(II) bis(3-(trifluoromethyl)-5-(4-t-butylpyridyl)-1,2,4-triazolate)dimethylphenylphosphine, bis[2-(4-n-hexylphenyl)quinoline](acetylacetonate) iridium(III), tris[2-(4-n-hexylphenyl)quinoline] iridium(III), tris[2-phenyl-4-methylquinoline] iridium(III), bis(2-phenylquinoline)(2-(3-methylphenyl)pyridinate) iridium(III), bis(2-(9,9-diethylfluoren-2-yl)-1-phenyl-1H-benzo[d]imidazolato)(acetylacetonate) iridium(III), bis(2-phenylpyridine)(3-(pyridin-2-yl)-2H-chromen-9-onate) iridium(III), bis(2-phenylquinoline)(2,2,6,6-tetramethylheptane-3,5-dionate) iridium(III), bis(phenylisoquinoline)(2,2,6,6-tetramethylheptane-3,5-dionate) iridium(III), iridium(III) bis(4-phenylthieno[3,2-c]pyridinato-N,C^{2'})acetylacetonate, (E)-2-(2-t-butyl-6-(2-(2,6,6-trimethyl-2,4,5,6-tetrahydro-1H-pyrrolo[3,2,1-ij]quinolin-8-yl)vinyl)-4H-pyran-4-ylidene)-malononitrile, bis(3-trifluoromethyl-5-(1-isoquinolyl)pyrazolate)(methyl-diphenylphosphine) ruthenium, bis[(4-n-hexylphenyl)isoquinoline](acetylacetonate) iridium(III), platinum(II) octaethylporphin, bis(2-methyldibenzo[f,h]quinoxaline)(acetylacetonate) iridium(III) and tris[(4-n-hexylphenyl)isoquinoline] iridium(III).

Specific examples of electron transport layer/hole-blocking layer-forming materials include lithium 8-hydroxyquinolinolate, 2,2',2"-(1,3,5-benzinetriyl)-tris(1-phenyl-1-H-benzimidazole), 2-(4-biphenyl)-5-(4-t-butylphenyl)-1,3,4-oxadiazole, 2,9-dimethyl-4,7-diphenyl-1,10-phenanthroline, 4,7-diphenyl-1,10-phenanthroline, bis(2-methyl-8-quinolinolate)-4-(phenylphenolato)aluminum, 1,3-bis[2-(2,2'-bipyridin-6-yl)-1,3,4-oxadiazo-5-yl]benzene, 6,6'-bis[5-(biphenyl-4-yl)-1,3,4-oxadiazo-2-yl]-2,2'-bipyridine, 3-(4-biphenyl)-4-phenyl-5-t-butylphenyl-1,2,4-triazole, 4-(naphthalen-1-yl)-3,5-diphenyl-4H-1,2,4-triazole, 2,9-bis(naphthalen-2-yl)-4,7-diphenyl-1,10-phenanthroline, 2,7-bis[2-(2,2'-bipyridin-6-yl)-1,3,4-oxadiazo-5-yl]-9,9-dimethylfluorene, 1,3-bis[2-(4-t-butylphenyl)-1,3,4-oxadxazo-5-yl]benzene, tris(2,4,6-trimethyl-3-(pyridin-3-yl)phenyl)borane, 1-methyl-2-(4-(naphthalen-2-yl)phenyl)-1H-imidazo-[4,5f][1,10]phenanthroline, 2-{naphthalen-2-yl)-4,7-diphenyl-1,10-phenanthroline, phenyldipyrenylphosphine oxide, 3,3',5,5'-tetra[(m-pyridyl)phen-3-yl]biphenyl, 1,3,5-tris[(3-pyridyl)phen-3-yl]benzene, 4,4'-bis(4,6-diphenyl-1,3,5-triazin-2-yl)biphenyl, 1,3-bis[3,5-di(pyridin-3-yl)phenyl]benzene, bis(10-hydroxybenzo[h]quinolinato)beryllium, diphenylbis(4-(pyridin-3-yl)phenyl)silane and 3,5-di(pyren-1-yl)pyridine.

Examples of electron injection layer-forming materials include lithium oxide (Li₂O), magnesium oxide (MgO), alumina (Al₂O₃), lithium fluoride (LiF), sodium fluoride (NaF), magnesium fluoride (MgF₂), cesium fluoride (CsF), strontium fluoride (SrF₂), molybdenum trioxide (MoO₃), aluminum, Li(acac), lithium acetate and lithium benzoate.

Examples of cathode materials include aluminum, magnesium-silver alloys, aluminum-lithium alloys, lithium, sodium, potassium and cesium.

An example of an electron-blocking layer-forming material is tris(phenylpyrazole) iridium.

The manufacture of PLED devices, although not particularly limited, is exemplified by the following method.

A PLED device can be fabricated by, in the fabrication of an OLED device as described above, successively forming a hole-transporting polymer layer and a light-emitting polymer layer instead of forming a hole transport layer, an emissive layer, an electron transport layer and an electron injection layer.

The cathode and anode materials used here may be similar to those used when fabricating an OLED device as described above, and similar cleaning treatment and surface treatment may be carried out.

The method of forming the hole-transporting polymer layer and the light-emitting polymer layer is exemplified by a film-forming method in which a solvent is added to a hole-transporting polymer material or a light-emitting polymer material, or a material obtained by adding a dopant to either of these materials, so as to dissolve or uniformly disperse the material, following which the resulting solution or dispersion is coated onto the hole injection layer or hole-transporting polymer layer and is subsequently baked.

Examples of hole-transporting polymer materials include poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-penten-5'-yl}fluorenyl-2,7-diyl)-co-(N,N'-bis{p-butylphenyl}-1,4-diaminophenylene}], poly[N,N'-bis(4-butylphenyl)-N,N'-bis(phenyl)benzidine] end-capped with polysilsesquioxane and poly[(9,9-dioctylfluorenyl-2,7-diyl)-co-(4,4'-(N-(p-butylphenyl))diphenylamine)].

Examples of light-emitting polymer materials include polyfluorene derivatives such as poly(9,9-dialkylfluorene) (PDAF), poly(phenylene vinylene) derivatives such as poly(2-methoxy-5-(2'-ethylhexoxy)-1,4-phenylene vinylene) (MEH-PPV), polythiophene derivatives such as poly(3-alkylthiophene) (PAT), and polyvinylcarbazole (PVCz).

Examples of the solvent include toluene, xylene and chloroform. Examples of the method of dissolution or uniform dispersion include stirring, stirring under applied heat, and ultrasonic dispersion.

Examples of the coating method include, but are not particularly limited to, inkjet printing, spray coating, dipping, spin coating, transfer printing, roll coating and brush coating. Coating is preferably carried out in an inert gas atmosphere such as nitrogen or argon.

Examples of the baking method include methods that involve heating in an oven or on a hot plate, either within an inert gas atmosphere or in a vacuum.

### EXAMPLES

Synthesis Examples, Production Examples, Working Examples, and Comparative Examples are given below to more concretely illustrate the invention, although the invention is not limited by these Examples. The instruments and other equipment used in the Examples were as follows.

**[¹H-NMR]**

| | |
|---|---|
| Instruments: | Varian NMR System 400 NB (400 MHz) JEOL-ECA700 (700 MHz) |
| Solvent used in measurement: | DMSO-d6 |
| Reference material: | Tetramethylsilane (TMS) (δ = 0.0 ppm) |

**[GPC]**

| | |
|---|---|
| Instrument: | HLC-8200 GPC (Tosoh Corporation) |
| Columns: | Shodex KF-804L + KF-805L |
| Column temperature: | 40°C |
| Solvent: | Tetrahydrofuran (THF) |
| Detector: | UV (254 nm) |
| Calibration curve: | polystyrene standard |

**[Ellipsometer]**

| | |
|---|---|
| Instrument: | VASE multiple incident angle spectroscopic ellipsometer (JA Woollam Japan) |

**[Thermogravimetric/Differential Thermal Analyzer (TG-DTA)]**

| | |
|---|---|
| Instrument: | TG-8120 (Rigaku Corporation) |
| Temperature ramp-up rate: | 10°C/min |
| Measurement temperatures: | 25°C to 750°C |

**[Measurement of Light Scattering Film Thickness]**

| | |
|---|---|
| Instrument: | ET-4000, from Kosaka Laboratory, Ltd. |

**[Surface Resistance]**

| | |
|---|---|
| Instrument: | EC-80, from NAPSON Corporation |

**[Substrate Cleaning]**

| | |
|---|---|
| Apparatus: | Substrate cleaning machine (low-pressure plasma-type), from Choshu Industry Co., Ltd. |

**[Fabrication of EL Device]**

| | |
|---|---|
| Apparatus: | C-E2L1G1-N Multifunction Vapor Deposition System, from Choshu Industry Co., Ltd. |

**[Measurement of EL Device Brightness]**

| | |
|---|---|
| Instrument: | I-V-L Measurement System from Tech World, Inc. |

### [1] Synthesis of Triazine Ring-Containing Hyperbranched Polymer

### [Synthesis Example 1] Synthesis of HB-TmDA

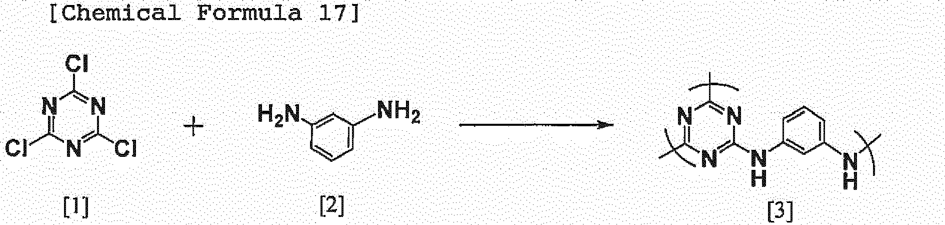

Under nitrogen, 456.02 g of DMAc was added to a 1,000 mL four-neck flask and cooled to -10°C in an acetone-dry ice bath, following which 84.83 g (0.460 mol) of 2,4,6-trichloro-1,3,5-triazine [1] (Evonik Degussa) was added and dissolved therein. Next, a solution of 62.18 g (0.575 mol) of m-phenylenediamine [2] dissolved in 304.01 g of DMAc, and 14.57 g (0.156 mol) of aniline were added dropwise. After dropwise addition, the flask contents were stirred for 30 minutes. Next, using a fluid transfer pump, the reaction mixture was added dropwise over a period of 1 hour to a 2,000 mL four-neck flask that already contained 621.85 g of DMAc and had been heated beforehand to 85°C on an oil bath. Following addition of the reaction mixture, stirring was carried out for 1 hour, effecting polymerization. Next, aniline (113.95 g, 1.224 mol) was added and the flask contents were stirred for 1 hour, bringing the reaction to completion. The system was cooled to room temperature in an ice bath, after which triethylamine (116.36 g, 1.15 mol) was added dropwise and 30 minutes of stirring was carried out, thereby quenching the hydrochloric acid. The hydrochloride that settled out was then removed by filtration. The filtered reaction mixture was reprecipitated in a mixed solution of 28% ammonia water (279.29 g) and deionized water (8,820 g). The precipitate was filtered, dried in a vacuum desiccator at 150°C for 8 hours, then redissolved in THF (833.1 g) and reprecipitated in deionized water (6,665 g). The resulting precipitate was filtered, then dried in a vacuum desiccator at 150°C for 25 hours, yielding 118.0 g of the target polymer compound [3] (referred to below as "HB-TmDA40").

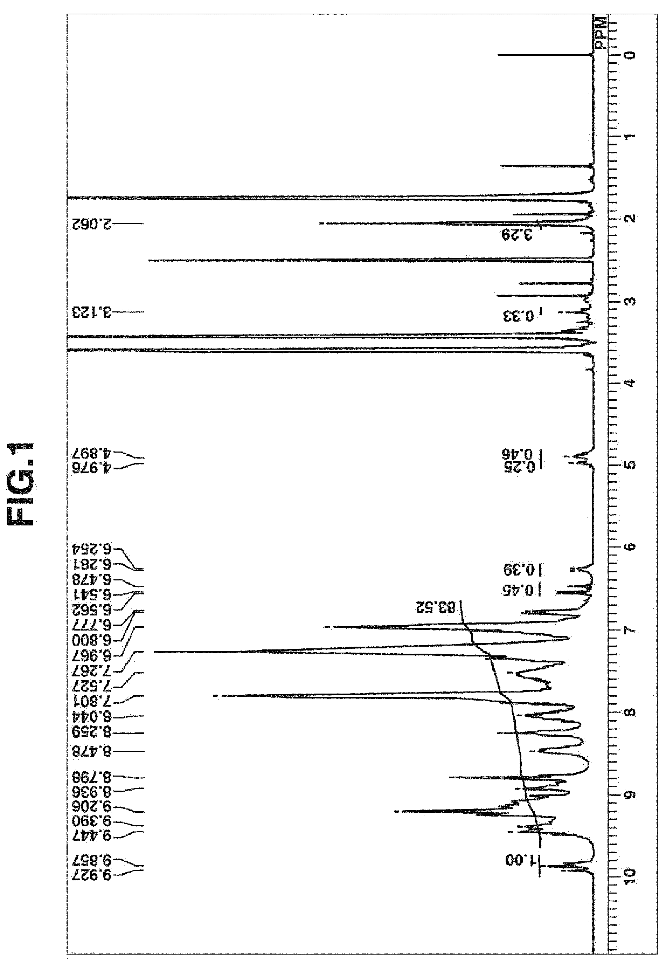

FIG. 1 shows the measured ¹H-NMR spectrum for HB-TmDA40. The HB-TmDA40 thus obtained is a compound having structural. units of formula (1). The polystyrene-equivalent weight-average molecular weight Mw of HB-TmDA40, as measured by GPC, was 4,300, and the polydispersity Mw/Mn was 3.44.

### (1) Heat Resistance Test

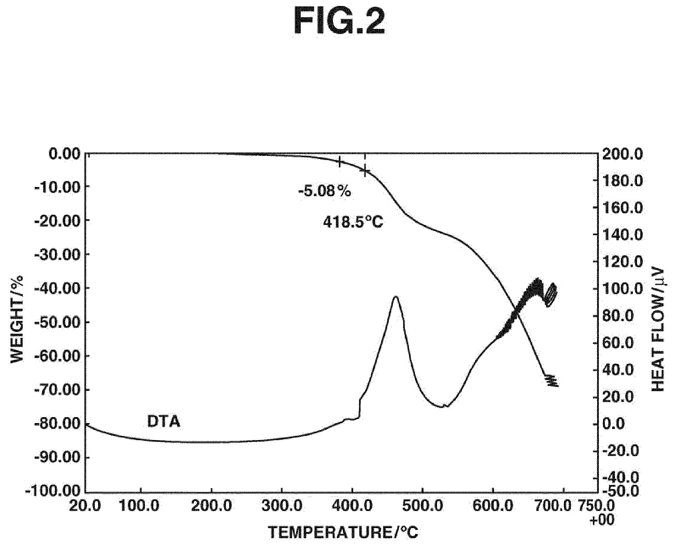

TG-DTA measurement was carried out on the HB-TmDA40 obtained in Synthesis Example 1, whereupon the 5% weight loss temperature was 419°C. The results are shown in FIG. 2.

### (2) Measurement of Refractive Index

The HB-TmDA40 obtained in Synthesis Example 1 (0.5 g) was dissolved in 4.5 g of cyclohexanone, giving a clear, light yellow-colored solution. Using a spin coater, the resulting polymer varnish was spin-coated onto a glass substrate at 200 rpm for 5 seconds and at 2,000 rpm for 30 seconds, following which the solvent was removed by heating at 150°C for 1 minute and at 250°C for 5 minutes, thereby giving a film. Upon measurement, the resulting film was found to have a refractive index at 550 nm of 1.790.

### [2] Production of ITO Substrates

### [Production Example 1]

A 20 wt % solution (referred to below as "HB-TmDA40V") was prepared by dissolving 40 g of the HB-TmDA40 obtained in Synthesis Example 1 in 153.6 g of cyclohexanone and 6.4 g of deionized water.

### [Production Example 2] Preparation of Light Diffusing Particle Dispersion

First, 70.0 g of titanium oxide particles (the rutile-type titanium oxide JA-600A), 272.3 g of cyclohexanone, 7.0 g of 3-methacryloxypropyltriethoxysilane (KBE-503, from Shin-Etsu Chemical Co., Ltd.) and 0.7 g of deionized water were added together and stirred for 3 hours at 60°C. Next, 84.7 g of the solution HB-TmDA40V prepared in Production Example 1 was added to 296.4 g of this dispersion, and dispersion was carried out with an ultrahigh-speed universal-type homogenizer (here and below, Physcotron NS-56S, from Microtec Co., Ltd.). The resulting dispersion was filtered with a syringe filter (this dispersion is referred to below as "JA600A-KBE10-D").

### [Production Example 3] Film-Forming Composition 1

A dispersion (referred to below as "HB-TmDA40-V-F") was prepared by adding together 874.6 g of the solution HB-TmDA40V prepared in Production Example 1, 50.1 g of the crosslinking agent B-882N (Mitsui Chemicals, Inc.), 1.75 g of a 5 wt % cyclohexanone solution of the surfactant Megafac F-554 (DIC Corporation), and 473.5 g of cyclohexanone/deionized water (96/4, wt/wt).

### [Production Example 4] Film-Forming Composition 2

A dispersion (referred to below as "HB-TmDA40-L1-70") was prepared by adding together 526.3 g of the solution HB-TmDA40V prepared in Production Example 1, 359.4 g of Lightstar LA-OS20PGM (Nissan Chemical Industries, Ltd.), 30.2 g of the crosslinking agent B-882N (Mitsui Chemicals, Inc.) and 84.1 g of cyclohexanone/deionized water (96/4, wt/wt).

### [Production Example 5] Film-Forming Composition 3

A dispersion (referred to below as "HB-TmDA40-JA600A-KBE10-70") was prepared by adding together 294.7 g of the solution HB-TmDA40V prepared in Production Example 1, 331.6 g of the dispersion JA600A-KBE10-D prepared in Production Example 2, 21.1 g of a crosslinking agent (B-882N) and 52.6 g of cyclohexanone/deionized water (96/4, wt/wt).

### [Production Example 6] Fabrication 1 of ITO Substrate

Film formation was carried out by spin-coating the dispersion HB-TmDA40-V-F prepared in Production Example 3 onto an alkali-free glass substrate for 5 seconds at 200 rpm and for 30 seconds at 1,000 rpm. The applied film was dried for 1 minute at 100°C and then for 1 hour at 250°C to give a cured film. The thickness of the cured film was measured and found to be 970 nm.

Next, using a sputtering system (SRS-700T/LL, from Sanyu Electron Co., Ltd.), ITO was RF sputtered onto the cured film under conditions of 22°C, 350 W power and 7 minutes, thereby giving an ITO substrate (referred to below as "G-HB-ITO"). The thickness of the ITO film was 250 nm.

The surface resistance of the resulting ITO substrate was measured and found to be 113 Ω/cm².

### [Production Example 7] Fabrication 2 of ITO Substrate

Film formation was carried out by spin-coating the dispersion HB-TmDA40-L1-70 prepared in Production Example 4 onto an alkali-free glass substrate for 5 seconds at 200 rpm and for 30 seconds at 1,000 rpm. The applied film was dried for 1 minute at 100° C and then for 1 hour at 250° C to give a cured film. The thickness of the cured film was measured and found to be 1.7 µm.

Film formation was again carried out by spin-coating the dispersion HB-TmDA40-V-F prepared in Production Example 3 onto the resulting substrate for 5 seconds at 200 rpm and for 30 seconds at 1,000 rpm. The applied film was dried for 1 minute at 100° C and then for 1 hour at 250° C to give a cured film. The thickness of the cured film was measured and found to be 1.0 µm.

Next, using a sputtering system (SRS-700T/LL, from Sanyu Electron Co., Ltd.), ITO was RF sputtered onto the cured film under conditions of 22°C, 350 W power and 7 minutes, thereby giving an ITO substrate (referred to below as "G-L-HB-ITO"). The thickness of the ITO film was 250 nm.

The substrate was baked for 1 hour at 150°C and the surface resistance of the resulting ITO substrate was measured and found to be 65 Ω/cm².

### [Production Example 8] Fabrication 3 of ITO Substrate

Film formation was carried out by spin-coating the dispersion HB-TmDA40-JA600A-KBE10-70 prepared in Production Example 5 onto an alkali-free glass substrate for 5 seconds at 200 rpm and for 30 seconds at 1,000 rpm. The applied film was dried for 1 minute at 100° C and then for 1 hour at 250° C to give a cured film. The thickness of the cured film was measured and found to be 1.0 µm.

Film formation was again carried out by spin-coating the dispersion HB-TmDA40-V-F prepared in Production Example 3 onto the resulting substrate for 5 seconds at 200 rpm and for 30 seconds at 1,000 rpm. The applied film was dried for 1 minute at 100°C and then for 1 hour at 250°C to give a cured film. The thickness of the cured film was measured and found to be 1.0 µm.

Next, using a sputtering system (SRS-700T/LL, from Sanyu Electron Co., Ltd.), ITO was RF sputtered onto the cured film under conditions of 22°C, 350 W power and 7 minutes, thereby giving an ITO substrate (referred to below as "G-L-HB-ITO"). The thickness of the ITO film was 250 nm.

The surface resistance of the resulting ITO substrate was measured and found to be 85 Ω/cm².

### [Production Example 9]

An ITO substrate (referred to below as G-ITO) was obtained by using a sputtering system to RF sputter ITO under conditions of 22°C, 350 W power and 7 minutes onto an alkali-free glass substrate. The ITO film thickness was 250 nm.

The surface resistance of the resulting ITO substrate was measured and found to be 77 Ω/cm².

### [3] Fabrication of Organic EL Devices, and Evaluation of Properties

### [Working Example 1]

Before charging the ITO substrate (G-L-HB-ITO) obtained in Production Example 7 into a vapor deposition system, impurities on the surface of the substrate were removed with an O₂ plasma cleaning system (150 W, 30 seconds).

Next, using a vapor deposition system (degree of vacuum, 1.0×10⁻⁵ Pa), a 30 nm film of HAT-CN having the structure shown below was formed, at a rate of 0.2 nm/s, as a hole injection layer on the cleaned ITO substrate. This was followed by the formation, at a rate of 0.2 nm/s, of a 100 nm film of α-NPD having the structure shown below as a hole transport layer. Next, CBP and Ir(PPy)₃ having the structures shown below were co-vapor deposited as the emissive layer. Co-vapor deposition was carried out by controlling the vapor deposition rate so that the Ir(PPy)₃ concentration becomes 6% and building the layer up to 40 nm. Next, BAlq having the structure shown below as the electron transport layer, lithium fluoride as the electron injection layer and an aluminum thin-film as the cathode were successively deposited, thereby giving an organic EL device. At this time, vapor deposition was carried out at a rate of 0.2 nm/s for BAlq and aluminum, and at a rate of 0.02 nm/s for lithium fluoride. The film thicknesses were set to, respectively, 20 nm, 0.5 nm and 100 nm.

To prevent the device characteristics from deteriorating due to the effects of oxygen, moisture and the like in air, the organic EL devices were sealed with sealing substrates, after which the characteristics were evaluated. Sealing was carried out as follows. The organic EL device was placed between sealing substrates in a nitrogen atmosphere having an oxygen concentration of not more than 2 ppm and a dew point of -85°C or below, and the sealing substrates were laminated together using an adhesive (XNR5516Z-B1, from Nagase ChemteX Corporation). A desiccant (HD-071010W-40, from Dynic Corporation) was placed, together with the organic EL device, within the sealing substrates at this time. The adhesive was cured by irradiating the laminated sealing substrates with UV light (wavelength, 365 nm; dosage, 6,000 mJ/cm²), then annealing at 80°C for 1 hour.

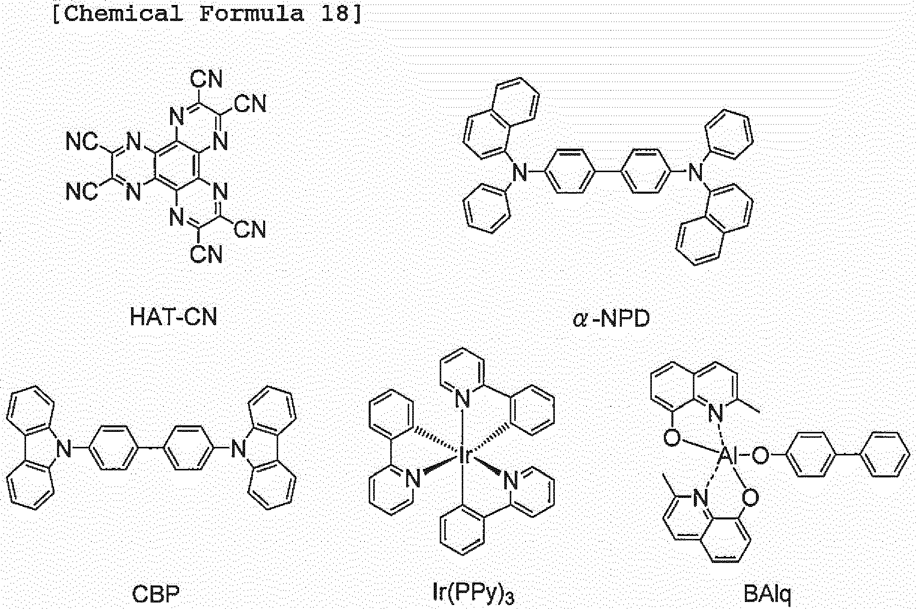

### [Working Example 2]

Aside from using the ITO substrate G-J-HB-ITO obtained in Production Example 8 instead of the ITO substrate G-L-HB-ITO obtained in Production Example 7, an organic EL device was fabricated in the same way as in Working Example 1.

### [Comparative Example 1]

Aside from using the ITO substrate G-HB-ITO obtained in Production Example 6 instead of the ITO substrate G-L-HB-ITO obtained in Production Example 7, an organic EL device was fabricated in the same way as in Working Example 1.

### [Comparative Example 2]

Aside from using the ITO substrate G-ITO obtained in Production Example 9 instead of the ITO substrate G-L-HB-ITO obtained in Production Example 7, an organic EL device was fabricated in the same way as in Working Example 1.

The driving voltages, current densities and current efficiencies at a brightness of 3,000 cd/m² were measured for each of the devices fabricated. The results are shown in Table 1.

**[Table 1]**

| | Characteristics at 3,000 cd/m² | | | Efficiency ratio |
|---|---|---|---|---|
| | Voltage (V) | Current density (mA/cm²) | Current efficiency (cd/A) | |
| Comparative Example 2 | 9.1 | 10.3 | 29.2 | 1.00 |
| Comparative Example 1 | 9.4 | 10.4 | 28.8 | 0.99 |
| Working Example 1 | 8.9 | 8.8 | 34.3 | 1.17 |
| Working Example 2 | 8.7 | 6.4 | 46.7 | 1.60 |

As shown in Table 1, setting the current efficiency of the device in Comparative Example 2 to an arbitrary value of 1.00, the current efficiencies of the respective devices in Comparative Example 1 and Working Examples 1 and 2 were 0.99, 1.17 and 1.60. This shows that the organic EL devices according to the invention which use an ITO electrode that includes a specific light scattering film have excellent current efficiencies.

## Claims

1. An organic electroluminescence device **characterized by** comprising a light scattering film obtained by curing a light scattering film-forming composition comprising a triazine ring-containing polymer which includes a recurring unit structure of formula (1) below 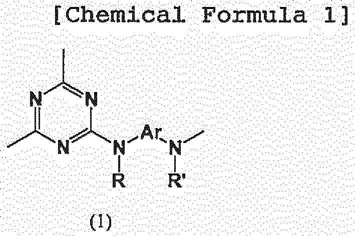 (wherein R and R' are each independently a hydrogen atom, an alkyl group, an alkoxy group, an aryl group or an aralkyl group; and Ar is at least one moiety selected from the group consisting of moieties of formulas (2) to (13) below 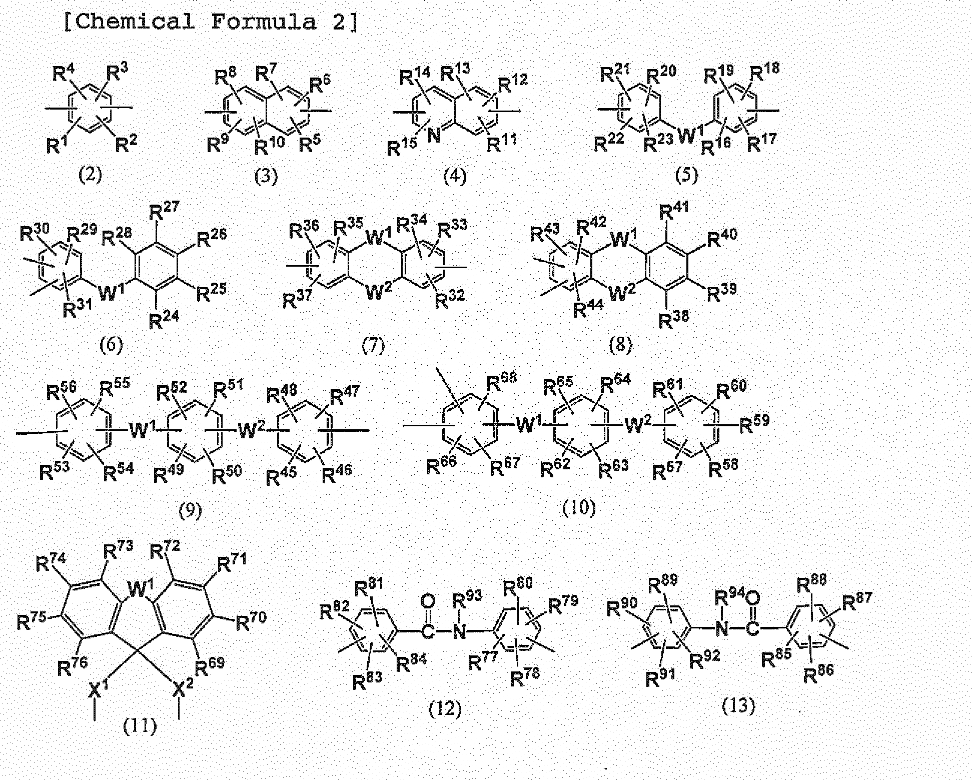 (in which R¹ to R⁹² are each independently a hydrogen atom, a halogen atom, a carboxyl group, a sulfo group, an alkyl group of 1 to 10 carbon atoms which may have a branched structure, or an alkoxy group of 1 to 10 carbon atoms which may have a branched structure; R⁹³ and R⁹⁴ are hydrogen atoms or alkyl groups of 1 to 10 carbon atoms which may have a branched structure; W¹ and W² are each independently a single bond, CR⁹⁵R⁹⁶ (R⁹⁵ and R⁹⁶ being each independently a hydrogen atom or an alkyl group of 1 to 10 carbon atoms which may have a branched structure, with the proviso that R⁹⁵ and R⁹⁶ may together form a ring), C=O, O, S, SO, SO₂ or NR⁹⁷ (R⁹⁷ being a hydrogen atom or an alkyl group of 1 to 10 carbon atoms which may have a branched structure); and X¹ and X² are each independently a single bond, an alkylene group of 1 to 10 carbon atoms which may have a branched structure, or a group of formula (14) below 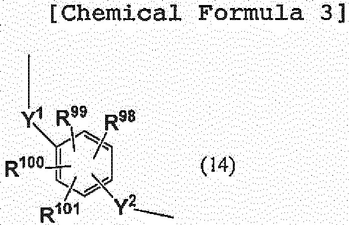 (R⁹⁸ to R¹⁰¹ being each independently a hydrogen atom, a halogen atom, a carboxyl group, a sulfo group, an alkyl group of 1 to 10 carbon atoms which may have a branched structure, or an alkoxy group of 1 to 10 carbon atoms which may have a branched structure; and Y¹ and Y² being each independently a single bond or an alkylene group of 1 to 10 carbon atoms which may have a branched structure))), a crosslinking agent, and a light diffusing agent.

2. The organic electroluminescence device of claim 1, wherein the light-diffusing agent has an average particle size of 100 nm to 3 µm.

3. The organic electroluminescence device of claim 1 or 2, wherein the light diffusing agent is one or more selected from among organic-inorganic composite light diffusing agents, organic light diffusing agents and inorganic light diffusing agents.

4. The organic electroluminescence device of claim 3, wherein the light diffusing agent is titanium oxide.

5. The organic electroluminescence device of claim 4, wherein the light diffusing agent is titanium oxide treated with a surface modifying agent.

6. The organic electroluminescence device of claim 3, wherein the light diffusing agent is agglomerated silica particles.

7. The organic electroluminescence device of claim 6, wherein the light diffusing agent is agglomerated silica particles treated with a surface modifying agent.

8. The organic electroluminescence device of any one of claims 1 to 7, wherein the crosslinking agent is a blocked isocyanate-containing compound.

9. The organic electroluminescence device of any one of claims 1 to 8, wherein the light scattering film forms a light extraction layer.
